# EUROPEAN PATENT APPLICATION

(11) **EP 4 542 653 A1**
(43) Date of publication of application: **23.04.2025**
(21) Application number: 23842392.5
(22) Date of filing: 20.07.2023
(51) Int. Cl.: H01L 27/15, H01L 33/58, H01L 33/00

(54) **DISPLAY PANEL AND ELECTRONIC DEVICE**

(30) Priority: 22.07.2022 CN 202210871098
(71) Applicant: Huawei Technologies Co., Ltd., Shenzhen, Guangdong 518129 (CN)
(72) Inventor: LIU, Jinqiang, Shenzhen, Guangdong 518129 (CN); JIANG, Fulong, Shenzhen, Guangdong 518129 (CN); WANG, Lei, Shenzhen, Guangdong 518129 (CN); DING, Zhaoyi, Shenzhen, Guangdong 518129 (CN); YANG, Lei, Shenzhen, Guangdong 518129 (CN); ZHANG, Li, Shenzhen, Guangdong 518129 (CN)
(74) Representative: Pfenning, Meinig & Partner mbB
(86) International application number: PCT/CN2023/108378
(87) International publication number: WO 2024/017330

(57) **Abstract**

This application provides a display panel and an electronic device. The display panel includes a drive backplane, a filling layer, and a plurality of pixel structures. The filling layer is fastened to the drive backplane. The plurality of pixel structures are fastened to the drive backplane at intervals and are embedded in the filling layer. The drive backplane is configured to drive the plurality of pixel structures to emit light. The filling layer includes an insulation layer and a light shielding layer. The insulation layer includes a bottom wall and a side wall. The bottom wall of the insulation layer and the side wall of the insulation layer form first accommodation space. The bottom wall of the insulation layer is fastened to the drive backplane. The side wall of the insulation layer is fastened to a side surface of the pixel structure. The light shielding layer is located in the first accommodation space and fastened to the insulation layer. In this way, insulation protection is performed on adjacent pixel structures through the insulation layer, and light emitted from the side surface of the pixel structure is shielded through the light shielding layer, to avoid optical crosstalk between two adjacent pixel structures.

## Description

This application claims priority to Chinese Patent Application No. 202210871098.2, filed with the China National Intellectual Property Administration on July 22, 2022 and entitled "DISPLAY PANEL AND ELECTRONIC DEVICE", which is incorporated herein by reference in its entirety.

### TECHNICAL FIELD

This application relates to the field of display device technologies, and in particular, to a display panel and an electronic device.

### BACKGROUND

In a micro light emitting diode (Micro Light Emitting Diode, Micro LED) display panel, conventional LEDs are arranged in an array and miniaturized to form pixels at ultra-small pitches, to implement high pixels. However, after a pitch between adjacent pixel structures is reduced, when the display panel displays a frame of picture, light emitted from a side surface of a pixel that is emitting light is quite prone to being propagated to an adjacent pixel that does not emit light. Consequently, optical crosstalk between the pixels becomes severe.

### SUMMARY

This application provides a display panel for preventing optical crosstalk and an electronic device.

According to a first aspect, an embodiment of this application provides a display panel. The display panel includes a drive backplane, a filling layer, and a plurality of pixel structures. The filling layer is fastened to the drive backplane. The plurality of pixel structures are fastened to the drive backplane at intervals and are embedded in the filling layer. The drive backplane is configured to drive the plurality of pixel structures to emit light. The filling layer includes an insulation layer and a light shielding layer. The insulation layer includes a bottom wall and a side wall. The bottom wall of the insulation layer and the side wall of the insulation layer form first accommodation space. The bottom wall of the insulation layer is fastened to the drive backplane. The side wall of the insulation layer is fastened to a side surface of the pixel structure. The light shielding layer is located in the first accommodation space and fastened to the insulation layer.

It may be understood that a part of the light emitted from the pixel structure is emitted from a top surface of the pixel structure, and the other part may be emitted from the side surface of the pixel structure. The filling layer is disposed between two adjacent pixel structures, and the filling layer includes the insulation layer and the light shielding layer. Therefore, insulation protection is performed on the two adjacent pixel structures through the insulation layer, and the light emitted from the side surface of the pixel structure is shielded through the light shielding layer. This avoids optical crosstalk between the two adjacent pixel structures, that is, light emitted from a side surface of one pixel structure is not easily propagated to the other pixel structure. In particular, when the display panel displays a frame of picture, if one of two adjacent pixel structures needs to emit light and the other does not emit light, light emitted from the pixel structure that is emitting light is not prone to crosstalk to the pixel structure that does not emit light.

In a possible implementation, the pixel structure includes a light emitting layer. A bottom surface of the light emitting layer faces the drive backplane. The light shielding layer includes a bottom surface. The bottom surface of the light shielding layer is fastened to the insulation layer. In a thickness direction of the display panel, a distance between the bottom surface of the light shielding layer and the drive backplane is less than or equal to a distance between the bottom surface of the light emitting layer and the drive backplane.

It may be understood that the distance between the bottom surface of the light shielding layer and the drive backplane is less than or equal to the distance between the bottom surface of the light emitting layer and the drive backplane, so that in two adjacent pixel structures, light emitted from a pixel structure can be prevented from being transmitted to an adjacent pixel structure through a bottom of the light shielding layer, and optical crosstalk is further avoided.

In a possible implementation, the pixel structure includes the light emitting layer. A top surface of the light emitting layer faces away from the drive backplane. The light shielding layer includes a top surface. The top surface of the light shielding layer faces away from the bottom wall of the insulation layer. In the thickness direction of the display panel, a distance between the top surface of the light shielding layer and the drive backplane is greater than or equal to a distance between the top surface of the light emitting layer and the drive backplane.

It may be understood that the distance between the top surface of the light shielding layer and the drive backplane is greater than or equal to the distance between the top surface of the light emitting layer and the drive backplane, so that light transmitted from the top surface of the light shielding layer to an adjacent pixel structure can be reduced, and the optical crosstalk can be further avoided.

In a possible implementation, the pixel structure includes the light emitting layer. An orthographic projection of the light emitting layer on the light shielding layer is located on the light shielding layer. In this way, in two adjacent pixel structures, light emitted from a pixel structure can be prevented from being transmitted to an adjacent pixel structure through the bottom of the light shielding layer, and the optical crosstalk is further avoided.

In a possible implementation, a material of the light shielding layer is a metal material.

It may be understood that, the material of the light shielding layer is the metal material, so that the light shielding layer can reflect the light emitted from the pixel structure, to avoid the optical crosstalk between two adjacent pixel structures, that is, light emitted from a side surface of one pixel structure is not easily propagated to the other pixel structure.

In addition, the material of the light shielding layer is the metal material, so that the light shielding layer may be further configured to assist the pixel structure in heat dissipation.

In a possible implementation, a material of the insulation layer is one or more of silicon dioxide, silicon nitride, silicon oxynitride, aluminum oxide, zirconium trioxide, hafnium dioxide, titanium dioxide, aluminum nitride, and zinc dioxide.

In a possible implementation, the light shielding layer includes a bottom wall and a side wall. The bottom wall of the light shielding layer and the side wall of the light shielding layer form second accommodation space. The bottom wall of the light shielding layer is fastened to the bottom wall of the insulation layer and the side wall of the insulation layer. The side wall of the light shielding layer is fastened to the side wall of the insulation layer. The filling layer further includes a dielectric layer. The dielectric layer is located in the second accommodation space, and is fastened to the light shielding layer.

It may be understood that, in comparison with a solution in which the light shielding layer fills the first accommodation space, a solution in which the first accommodation space is filled through cooperation between the light shielding layer of the metal material and the dielectric layer reduces thickness of the bottom wall of the light shielding layer in a direction perpendicular to the drive backplane, and reduces a risk of a short circuit of the light shielding layer.

In a possible implementation, the dielectric layer includes a top surface. The insulation layer includes a top surface. The top surface of the dielectric layer, the top surface of the light shielding layer, the top surface of the insulation layer, and a top surface of the pixel structure are flush. The top surface of the dielectric layer, the top surface of the light shielding layer, the top surface of the insulation layer, and the top surface of the pixel structure all face away from the drive backplane.

It may be understood that the top surface of the dielectric layer, the top surface of the light shielding layer, the top surface of the insulation layer, and the top surface of the pixel structure are flush, to form a flat surface. This facilitates subsequent disposing of other structures on the top surface of the dielectric layer, the top surface of the light shielding layer, the top surface of the insulation layer, and the top surface of the pixel structure.

In a possible implementation, the display panel further includes a conducting layer. The conducting layer is fastened to the top surface of the dielectric layer, the top surface of the light shielding layer, the top surface of the insulation layer, and the top surface of the pixel structure.

It may be understood that, when the drive backplane applies a current to the pixel structure, the conducting layer assists in diffusing the current, so that the current is quickly diffused to the pixel structures of the entire display panel, to improve light emission uniformity of the display panel.

In a possible implementation, the light shielding layer includes a first light shielding sublayer and a second light shielding sublayer, and adhesion between the first light shielding sublayer and the insulation layer is greater than adhesion between the second light shielding sublayer and the insulation layer.

The first light shielding sublayer includes a bottom wall and a side wall. The bottom wall of the first light shielding sublayer and the side wall of the first light shielding sublayer form third space. The bottom wall of the first light shielding sublayer is fastened to the bottom wall of the insulation layer and the side wall of the insulation layer. The side wall of the first light shielding sublayer is fastened to the side wall of the insulation layer.

The second light shielding sublayer is disposed in the third space. The second light shielding sublayer includes a bottom wall and a side wall. The bottom wall of the second light shielding sublayer is fastened to the bottom wall of the first light shielding sublayer and the side wall of the first light shielding sublayer. The side wall of the second light shielding sublayer is fastened to the side wall of the first light shielding sublayer. The bottom wall of the second light shielding sublayer and the bottom wall of the first light shielding sublayer form the bottom wall of the light shielding layer. The side wall of the second light shielding sublayer and the side wall of the first light shielding sublayer form the side wall of the light shielding layer.

The bottom wall of the second light shielding sublayer and the side wall of the second light shielding sublayer form fourth space, and the fourth space forms the second accommodation space.

It may be understood that both the first light shielding sublayer and the first light shielding sublayer may be configured to shield the light emitted from the side surface of the pixel structure. Adhesion between the first light shielding sublayer and the insulation layer is greater than adhesion between the second light shielding sublayer and the insulation layer, so that the first light shielding sublayer may be configured to enhance a connection between the second light shielding sublayer and the insulation layer, to reduce a risk of falling off of the second light shielding sublayer.

In a possible implementation, the light shielding layer includes a first light shielding sublayer and a second light shielding sublayer. Adhesion between the first light shielding sublayer and the insulation layer is greater than adhesion between the second light shielding sublayer and the insulation layer.

The first light shielding sublayer includes a bottom wall and a side wall. The bottom wall of the first light shielding sublayer is fastened to the bottom wall of the insulation layer and the side wall of the insulation layer, and the side wall of the first light shielding sublayer is fastened to the side wall of the insulation layer. The bottom wall of the first light shielding sublayer and the side wall of the first light shielding sublayer form third space, and the second light shielding sublayer fills the third space.

It may be understood that both the first light shielding sublayer and the first light shielding sublayer may be configured to shield the light emitted from the side surface of the pixel structure. Adhesion between the first light shielding sublayer and the insulation layer is greater than adhesion between the second light shielding sublayer and the insulation layer, so that the first light shielding sublayer may be configured to enhance a connection between the second light shielding sublayer and the insulation layer, to reduce a risk of falling off of the second light shielding sublayer.

In a possible implementation, the insulation layer includes a first insulation sublayer and a second insulation sublayer that are stacked, a material of the first insulation sublayer is non-silicon oxide or non-silicon nitride, and a material of the second insulation sublayer is silicon oxide or silicon nitride.

The first insulation sublayer includes a bottom wall and a side wall. The bottom wall of the first insulation sublayer is fastened to the drive backplane. The side wall of the first insulation sublayer is fastened to the side surface of the pixel structure. The bottom wall of the first insulation sublayer and the side wall of the first insulation sublayer form first space.

The second insulation sublayer is disposed in the first space. The second insulation sublayer includes a bottom wall and a side wall. The bottom wall of the second insulation sublayer is fastened to the bottom wall of the first insulation sublayer and the side wall of the first insulation sublayer. The side wall of the second insulation sublayer is fastened to the side wall of the first insulation sublayer. The bottom wall of the first insulation sublayer and the bottom wall of the second insulation sublayer form the bottom wall of the insulation layer, and the side wall of the first insulation sublayer and the side wall of the second insulation sublayer form the side wall of the insulation layer.

The bottom wall of the second insulation sublayer and the side wall of the second insulation sublayer form second space, and the second space forms the first accommodation space.

It may be understood that the first insulation sublayer may be configured to implement insulation between adjacent pixel structures, insulation between the drive backplane and the light shielding layer, and insulation between the pixel structures and the light shielding layer. In addition, the first insulation sublayer may further repair the side surface of the pixel structure. The second insulation sublayer may be configured to fill the first space of the first insulation sublayer. In this way, thickness of the insulation layer can be increased, and insulation effect can be enhanced.

In a possible implementation, the first insulation sublayer may be prepared by using an atomic layer deposition (atomic layer deposition, ALD) process. Thickness of the bottom wall and the side wall of the first insulation sublayer is greater than or equal to 5 nanometers, and less than or equal to 50 nanometers.

It may be understood that, when the first insulation sublayer is prepared by using the atomic layer deposition process, density of the first insulation sublayer is good, and the first insulation sublayer can fit the side surface of the pixel structure and cover a surface of the drive backplane, so that the insulation effect is good.

In a possible implementation, the second insulation sublayer may be prepared through plasma enhanced chemical vapor deposition (plasma enhanced chemical vapor deposition, PECVD). Thickness of the bottom wall and the side wall of the second insulation sublayer is greater than or equal to 5 nanometers and less than or equal to 500 nanometers.

It may be understood that, a preparation speed of preparing the second insulation sublayer by using the PECVD process is fast, which helps improve a processing speed.

In a possible implementation, the display panel further includes a conducting layer. The conducting layer is fastened to the top surface of the insulation layer, the top surface of the light shielding layer, and the top surface of the pixel structure, and the top surface of the pixel structure faces away from the drive backplane. The conducting layer is electrically connected to the pixel structure.

It may be understood that, when the drive backplane applies a current to the pixel structure, the conducting layer assists in diffusing the current, so that the current is quickly diffused to the pixel structures of the entire display panel, to improve light emission uniformity of the display panel.

In a possible implementation, the top surface of the insulation layer and the top surface of the light shielding layer are flush with the top surface of the pixel structure.

In a possible implementation, a height of the pixel structure in the thickness direction of the display panel is less than or equal to 2 micrometers, and a pitch between adjacent pixel structures is less than or equal to 2 micrometers.

It may be understood that a pitch between adjacent pixel structures is small, and a large quantity of pixel structures may be disposed in a limited area of a display region. This helps improve pixel density of the display panel. In this way, imaging quality of the display panel is good, so that a user can view a clear image.

In a possible implementation, a size of the display panel is less than or equal to 0.5 inch. The size of the display panel is a diagonal length of the display region of the display panel.

It may be understood that the size of the display panel is less than or equal to 0.5 inch, so that the display panel with a small size and light mass is obtained. In this way, the display panel requires small mounting space, and a limitation on a mounting location of the display panel is small. This facilitates mounting of the display panel. In addition, because the display panel is light in mass, when the display panel is applied to an electronic device, the electronic device can be implemented to be lightweight, to improve user experience.

In addition, as the size of the display panel becomes smaller, a pitch between two adjacent pixel structures becomes smaller. In this case, optical crosstalk between two adjacent imaging structures becomes increasingly severe. Therefore, for a miniaturized and lightweight display panel, optical crosstalk is severe, and display quality is poor. The filling layer is disposed between two adjacent pixel structures, the filling layer includes the insulation layer and the light shielding layer, and the light emitted from the side surface of the pixel structure is shielded by the light shielding layer, so that optical crosstalk between the two adjacent pixel structures is avoided, and the optical crosstalk of the miniaturized and lightweight display panel is resolved to a great extent.

Therefore, the filling layer is disposed, so that the display panel can be implemented to be miniaturized and lightweight, and good display quality can be ensured. In other words, optical crosstalk is not prone to occurring in two adjacent pixel structures.

According to a second aspect, an embodiment of this application provides an electronic device. The electronic device includes a bearing member and a display panel, and the bearing member is configured to bear the display panel.

It may be understood that the display panel is mounted on the bearing member, so that the display panel is not prone to generating optical crosstalk, and user experience of using the electronic device is good.

In a possible implementation, the bearing member includes a lens frame and a frame temple. The frame temple is connected to the lens frame, and the display panel is mounted on the frame temple.

It may be understood that the frame temple has good strength, and can well bear the display panel. In addition, the frame temple may further protect the display panel to some extent.

In a possible implementation, there are two display panels and two frame temples. The two frame temples are respectively connected to two ends of the lens frame, and the two display panels are respectively mounted on the two frame temples.

In a possible implementation, the electronic device includes augmented reality glasses, virtual reality glasses, mixed reality glasses, an augmented reality helmet, a virtual reality helmet, a mixed reality helmet, a head-up display device, or a projector.

### BRIEF DESCRIPTION OF DRAWINGS

To describe the technical solutions in embodiments of this application, the following describes the accompanying drawings used in embodiments of this application.
FIG. 1 is a diagram of a structure of an implementation of an electronic device according to an embodiment of this application;
FIG. 2 is a diagram of a structure of a display panel shown in FIG. 1;
FIG. 3 is a partial sectional view of an implementation of the display panel shown in FIG. 2 at a line A-A;
FIG. 4 is an enlarged diagram of the display panel shown in FIG. 3 at a location B;
FIG. 5 to FIG. 20 are partial sectional views of some corresponding preparation steps in a preparation method of a display panel;
FIG. 21 is a partial sectional view of another implementation of the display panel shown in FIG. 2 at A-A;
FIG. 22 is a partial sectional view of still another implementation of the display panel shown in FIG. 2 at A-A;
FIG. 23 is a partial sectional view of yet another implementation of the display panel shown in FIG. 2 at A-A; and
FIG. 24 is a diagram of a structure of an implementation of an electronic device according to an embodiment of this application.

### DESCRIPTION OF EMBODIMENTS

In the descriptions of embodiments of this application, it should be noted that, unless otherwise specified and limited, the term "connection" should be understood in a broad sense. For example, "connection" may be a detachable connection, or may be an undetachable connection. The connection may be a direct connection, or may be an indirect connection through an intermediate medium. Orientation terms mentioned in embodiments of this application, for example, "top", "bottom", "up", and "down" are merely directions with reference to the accompanying drawings. Therefore, the orientation terms are used to better and more clearly describe and understand embodiments of this application, instead of indicating or implying that a specified apparatus or element needs to have a specific orientation and be constructed and operated in the specific orientation, and therefore cannot be construed as a limitation on embodiments of this application. In the following, terms such as "first" and "second" are used only for description purposes, and cannot be understood as an indication or implication of relative importance or an implicit indication of a quantity of indicated technical features. Therefore, a feature limited by "first" or "second" may explicitly or implicitly include one or more features. In addition, "a plurality of" means at least two. Scenarios of a solution A and/or a solution B include the solution A, the solution B, and a solution AB.

The following describes embodiments of this application with reference to the accompanying drawings in embodiments of this application.

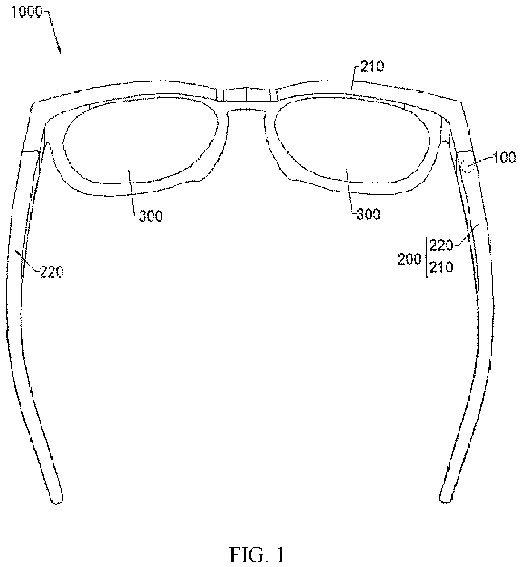

FIG. 1 is a diagram of a structure of an implementation of an electronic device 1000 according to an embodiment of this application. It should be noted that FIG. 1 merely schematically shows some components included in the electronic device 1000, and actual sizes, actual locations, and actual structures of these components are not limited by FIG. 1. The following accompanying drawings also merely schematically show some components, and actual sizes, actual locations, and actual structures of these components are not limited by the following accompanying drawings. Details are not described again in the following.

As shown in FIG. 1, this application provides an electronic device 1000. The electronic device 1000 may be an intelligent wearable device, for example, augmented reality (augmented reality, AR) glasses, virtual reality (virtual reality, VR) glasses, mixed reality (mixed reality, MR) glasses, a VR helmet, an AR helmet, or an MR helmet. The electronic device 1000 may alternatively be a head-up display (head-up display, HUD) device, a projector (projector), or the like. The electronic device 1000 in the embodiment shown in FIG. 1 is described by using AR glasses as an example.

As shown in FIG. 1, the electronic device 1000 includes a display panel 100, a glasses frame 200, and a lens 300. For example, the glasses frame 200 includes a lens frame 210 and a frame temple 220. There may be two frame temples 220. The two frame temples 220 may be respectively connected to two ends of the lens frame 210. The glasses frame 200 may form a bearing member of the electronic device 1000.

In some implementations, the lens 300 is mounted on the lens frame 210. The display panel 100 is mounted on the frame temple 220. In another implementation, a location of the display panel 100 is not specifically limited. It may be understood that a quantity of display panels 100 is not limited to one shown in FIG. 1. For example, there may be two display panels 100. The two display panels 100 may be respectively located on the two frame temples 220. There may alternatively be three display panels 100, and the display panels 100 are mounted on the frame temple 220 after being combined with x-cube. In addition, a quantity of lenses 300 is not limited to two shown in FIG. 1. For example, there may be one lens 300.

For example, an optical waveguide structure (not shown in the figure) may be disposed in the lens 300. In this way, when the display panel 100 emits light, the light is transmitted to the optical waveguide structure, and is transmitted to the front of an eye of a user under adjustment of the optical waveguide structure. In this case, the user may see an image of the display panel 100.

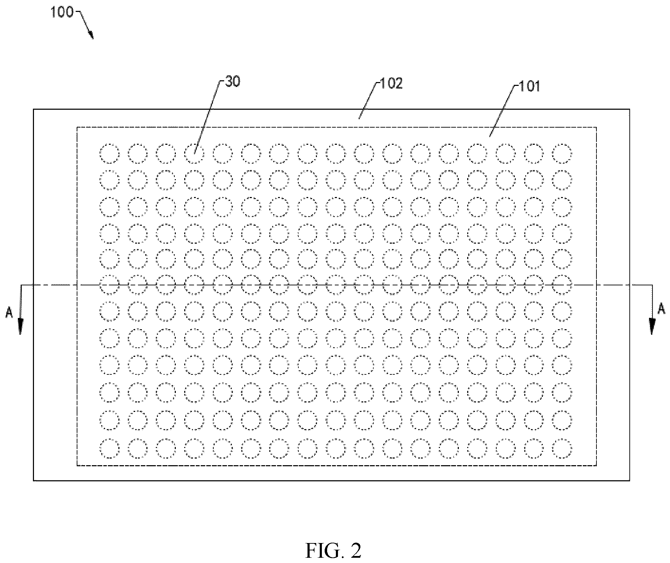

FIG. 2 is a diagram of a structure of the display panel 100 shown in FIG. 1.

As shown in FIG. 2, the display panel 100 includes a display region 101 and a non-display region 102. The non-display region 102 is connected to the display region 101. The display region 101 is configured to display an image. The non-display region 102 is located around the display region 101. The non-display region 102 may be configured to dispose a signal transmission line, and is configured to transmit an external signal to the display region 101 and/or transmit an external input signal to the display region 101.

In some implementations, a size of the display panel 100 is less than or equal to 0.5 inch. The size of the display panel 100 is a diagonal length of the display region 101. It may be understood that the size of the display panel 100 is less than or equal to 0.5 inch, so that the display panel 100 can be conveniently mounted on the frame temple 220. In addition, because the display panel 100 is light in mass, when the display panel 100 is applied to the electronic device 1000, the electronic device 1000 can be implemented to be lightweight, to improve user experience. In another implementation, the size of the display panel 100 may alternatively be greater than 0.5 inch.

It may be understood that the size of the display panel 100 may be adjusted based on an actual application scenario. In an implementation, the display panel 100 is an AR device, a volume of an optical receiver/transmitter is less than 1 cc, and the size of the display panel 100 is less than 0.3 inch. In an implementation, the display panel 100 is a VR device. To make a user have immersion experience, the size of the display panel may be greater than 0.7 inch.

In some implementations, pixel density of the display panel 100 is greater than or equal to 4000 pixels per inch (pixels per inch, PPI). In this way, imaging quality of the display panel 100 is good, so that the user can view a clear image. In another implementation, the pixel density of the display panel 100 may alternatively be less than 4000 PPI.

It may be understood that, in some implementations, the size of the display panel 100 is less than or equal to 0.5 inch, and the pixel density of the display panel 100 is greater than or equal to 4000 PPI, so that the display panel 100 can have a high resolution while the display panel is miniaturized and lightweight, and user experience is improved.

In some implementations, the display panel 100 may be a micro light emitting diode (Micro LED) display panel 100. There is a plurality of settings for a structure of the display panel 100. Details are described with reference to related accompanying drawings.

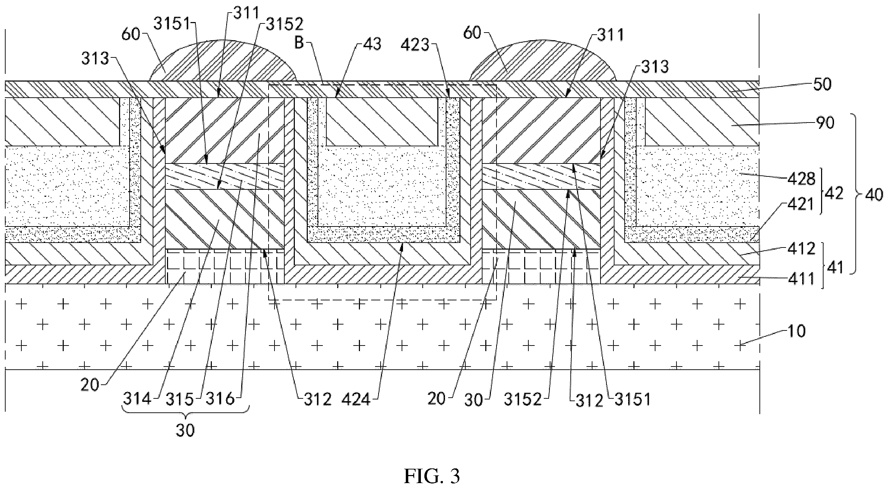

In some implementations, FIG. 3 is a partial sectional view of an implementation of the display panel 100 shown in FIG. 2 at a line A-A.

As shown in FIG. 3, the display region 101 of the display panel 100 includes a drive backplane 10, a bonding structure 20, a pixel structure 30, a filling layer 40, a conducting layer 50, and a microlens 60.

For example, the drive backplane 10 may be a complementary metal oxide semiconductor (complementary metal oxide semiconductor, CMOS) backplane. The drive backplane 10 may include a drive circuit. The drive circuit may be an active matrix drive circuit, or the drive circuit may be a passive matrix drive circuit.

As shown in FIG. 3, the bonding structure 20 is fastened to a surface of the drive backplane 10. There may be a plurality of bonding structures 20. The plurality of bonding structures 20 are fastened to the surface of the drive backplane 10 at intervals. The plurality of bonding structures 20 may be arranged in an array.

For example, the bonding structure 20 may include a conductive material and a non-conductive material. The conductive material may be one or more of gold (Au), tin (Sn), indium (In), copper (Cu), titanium (Ti), nickel (Ni), aluminum (Al), platinum (Pt), and tantalum (Ta). The non-conductive material may be one or more of polyimide (polyimide, PI), polydimethylsiloxane (polydimethylsiloxane, PDMS), photoresist, hydrogen silsesquioxane (hydrogen silsesquioxane, HSQ), and divinyl tetramethyl disiloxane bisbenzocyclobutene (divinyl tetramethyl disiloxane bisbenzocyclobutene, DVS BCB). The non-conductive material may alternatively be metal oxide or metal nitride, for example, may be one or more of aluminum oxide (AlO), aluminum nitride (AlN), titanium oxide (TiO), and titanium nitride (TiN).

In another implementation, the display region 101 may not include the bonding structure 20. The following and the accompanying drawings are described by using an example in which the display region 101 includes the bonding structure 20.

As shown in FIG. 2 and FIG. 3, the pixel structure 30 is fastened to a surface that is of the bonding structure 20 and that is away from the drive backplane 10, and the pixel structure 30 is electrically connected to the drive backplane 10 through the bonding structure 20. The drive backplane 10 is configured to drive a plurality of pixel structures 30 to emit light, and control the pixel structures 30 to be turned on and off. In one aspect, the bonding structure 20 may be configured to bond the drive backplane 10 and the pixel structure 30, to strengthen a connection between the pixel structure 30 and the drive backplane 10. In addition, a drive signal of the drive backplane 10 is transmitted to the pixel structure 30 through the bonding structure 20.

For example, there are a plurality of pixel structures 30. A quantity of pixel structures 30 may be the same as a quantity of bonding structures 20. The plurality of pixel structures 30 are fastened, in a one-to-one correspondence, to surfaces that are of the plurality of bonding structures 20 and that are away from the drive backplane 10. FIG. 3 schematically shows two pixel structures 30. A quantity of pixel structures 30 is not specifically limited.

For example, the plurality of pixel structures 30 may be arranged in an array.

For example, the drive backplane 10 may control pixel structures 30 at different locations to emit light or turn off light, to display images in different shapes and colors.

In another implementation, when the display region 101 does not include the bonding structure 20, the plurality of pixel structures 30 may be fastened to the drive backplane 10 at intervals.

As shown in FIG. 3, a height of the pixel structure 30 in a thickness direction of the display panel 100 (that is, in a direction perpendicular to the drive backplane 10) is less than or equal to 2 micrometers. In another implementation, the height of the pixel structure 30 in the thickness direction of the display panel 100 may alternatively be greater than 2 micrometers.

As shown in FIG. 3, a pitch between adjacent pixel structures 30 is less than or equal to 2 micrometers. It may be understood that the pitch between adjacent pixel structures 30 is less than or equal to 2 micrometers, and a large quantity of pixel structures 30 may be disposed in a limited area of the display region 101. This helps improve pixel density of the display panel 100. In this way, imaging quality of the display panel 100 is good, so that the user can view a clear image. In another implementation, an interval between adjacent pixel structures 30 may alternatively be greater than 2 micrometers.

It may be understood that one pixel structure 30 is equivalent to one pixel of the display panel 100. The pixel density of the display panel 100 is greater than or equal to 4000 PPI, that is, density of the pixel structures 30 of the display panel 100 is greater than or equal to 4000 PPI.

As shown in FIG. 3, the pixel structure 30 includes a top surface 311, a bottom surface 312, and a side surface 313. The top surface 311 and the bottom surface 312 are disposed away from each other, and the side surface 313 is connected between the top surface 311 and the bottom surface 312. The bottom surface 312 of the pixel structure 30 is fastened to the bonding structure 20. The top surface 311 of the pixel structure 30 faces away from the drive backplane 10.

For example, the pixel structure 30 includes a first semiconductor layer 314, a light emitting layer 315, and a second semiconductor layer 316 that are stacked. The light emitting layer 315 is located between the first semiconductor layer 314 and the second semiconductor layer 316, and the first semiconductor layer 314 is fastened to the bonding structure 20. The light emitting layer 315 includes a top surface 3151 and a bottom surface 3152 that are disposed away from each other. The top surface 3151 of the light emitting layer 315 is fastened to the second semiconductor layer 316. The bottom surface 3152 of the light emitting layer 315 is fastened to the first semiconductor layer 314. The top surface 3151 of the light emitting layer 315 faces away from the drive backplane 10, and the bottom surface 3152 of the light emitting layer 315 faces the drive backplane 10. It may be understood that a surface that is of the second semiconductor layer 316 and that is away from the light emitting layer 315 is the top surface 311 of the pixel structure 30. A surface that is of the first semiconductor layer 314 and that is away from the light emitting layer 315 is the bottom surface 3152 of the pixel structure 30. A side surface of the first semiconductor layer 314, a side surface of the light emitting layer 315, and a side surface of the second semiconductor layer 316 form the side surface 313 of the pixel structure 30.

In another implementation, the pixel structure 30 may alternatively be another structure including the light emitting layer 315.

In another implementation, when the display region 101 does not include the bonding structure 20, the first semiconductor layer 314 may be directly formed on the drive backplane 10.

For example, the light emitting layer 315 may be a multiple quantum well (multiple quantum well, MQW) layer including a plurality of well layers (well layers) and a plurality of barrier layers (barrier layers) that are alternately stacked. In another implementation, the light emitting layer 315 may alternatively be a single quantum well (single quantum well, SQW) layer. This is not limited in this application.

For example, the first semiconductor layer 314 is an N-type semiconductor layer or a P-type semiconductor layer, and the second semiconductor layer 316 is an N-type semiconductor layer or a P-type semiconductor layer. The first semiconductor layer 314 and the second semiconductor layer 316 are different types of semiconductor layers. In some implementations, the first semiconductor layer 314 is a P-type semiconductor layer, and the second semiconductor layer 316 is an N-type semiconductor layer.

The N-type semiconductor layer includes an N-type semiconductor, and the N-type semiconductor is a semiconductor mainly based on electron conduction. The P-type semiconductor layer includes a P-type semiconductor, and the P-type semiconductor is a semiconductor mainly based on hole conduction. When the drive backplane 10 applies a current to the pixel structure 30, electrons at the first semiconductor layer 314 may be compounded with holes at the second semiconductor layer 316, and emit energy in a form of photons at a location of the light emitting layer 315, that is, emit light at the light emitting layer 315.

It may be understood that a part of the light emitted from the pixel structure 30 is emitted from the top surface 311 of the pixel structure 30, and the other part may be emitted from the side surface 313 of the pixel structure 30.

As shown in FIG. 3, the filling layer 40 is fastened to the surface of the drive backplane 10. The filling layer 40, the pixel structure 30, and the bonding structure 20 are all located on a same side of the drive backplane 10. Both the pixel structure 30 and the bonding structure 20 are embedded in the filling layer 40. In this case, at least a part of the filling layer 40 is located between adjacent pixel structures 30. It may be understood that the pixel structure 30 is embedded in the filling layer 40, and the filling layer 40 may be fastened to both the top surface 311 and the side surface 313 of the pixel structure 30, or the filling layer 40 is fastened only to the side surface 313 of the pixel structure 30. When the filling layer 40 is fastened only to the side surface 313 of the pixel structure 30, the top surface 311 of the pixel structure 30 is completely exposed relative to the filling layer 40. In this application, an example in which the filling layer 40 is fastened only to the side surface 313 of the pixel structure 30 is used for description.

The pixel structure 30 and the bonding structure 20 are embedded in the filling layer 40, so that at least a part of the filling layer 40 can fill a gap between adjacent pixel structures 30, to enhance overall strength of the display panel 100. Under impact of external force, the filling layer 40 may provide specific cushioning, and overall reliability of the display panel 100 is good.

For example, the top surface 311 of the pixel structure 30 is flush with a top surface 43 of the filling layer 40, and the filling layer 40 completely fills a gap between adjacent pixel structures 30. It should be noted that, that the top surface 311 of the pixel structure 30 is flush with the top surface 43 of the filling layer 40 does not mean that the top surface 311 of the pixel structure 30 is absolutely flush with the top surface 43 of the filling layer 40. Within an allowable range of a process error, the top surface 311 of the pixel structure 30 and the top surface 43 of the filling layer 40 may have a specific deviation, for example, specific undulation disposing. In this way, flatness of the top surface 311 of the pixel structure 30 and the top surface 43 of the filling layer 40 is high.

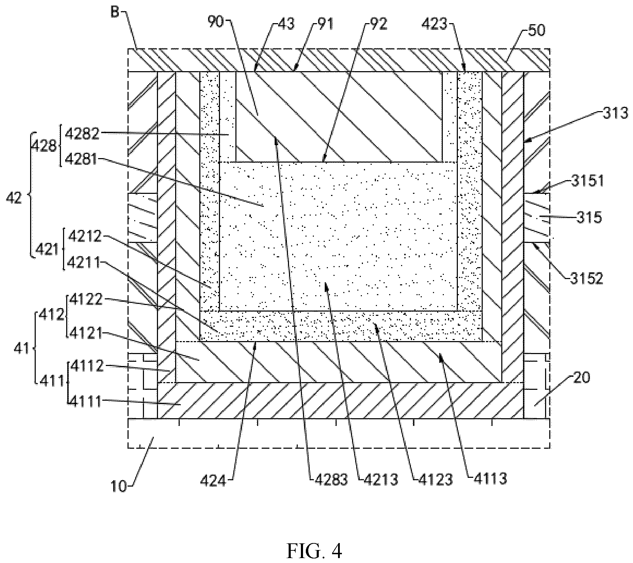

FIG. 4 is an enlarged diagram of the display panel 100 shown in FIG. 3 at a location B.

As shown in FIG. 3 and FIG. 4, the filling layer 40 may include a first insulation sublayer 411 and a second insulation sublayer 412 that are stacked. The second insulation sublayer 412 is located on a side that is of the first insulation sublayer 411 and that is away from the drive backplane 10. The first insulation sublayer 411 and the second insulation sublayer 412 may form the insulation layer 41 of the filling layer 40. In another implementation, the insulation layer 41 of the filling layer 40 may alternatively be of another structure.

For example, the first insulation sublayer 411 includes a bottom wall 4111 and a side wall 4112 (the bottom wall 4111 and the side wall 4112 are schematically distinguished by using dashed lines in FIG. 4). The bottom wall 4111 and the side wall 4112 of the first insulation sublayer 411 form first space 4113. The bottom wall 4111 is fastened to the drive backplane 10 and the bonding structure 20, and the side wall 4112 is fastened to the bonding structure 20 and the side surface 313 of the pixel structure 30. In another implementation, when a height of the bottom wall 4111 in a thickness direction of the display panel 100 is greater than a height of the bonding structure 20 in the thickness direction of the display panel 100, the side wall 4112 may alternatively be fastened only to the side surface 313 of the pixel structure 30.

For example, the second insulation sublayer 412 is fastened and connected to the first insulation sublayer 411, and the second insulation sublayer 412 is disposed in the first space 4113.

For example, the second insulation sublayer 412 includes a bottom wall 4121 and a side wall 4122 (the bottom wall 4121 and the side wall 4122 are schematically distinguished by using dashed lines in FIG. 4). The bottom wall 4121 and the side wall 4122 of the second insulation sublayer 412 form second space 4123. The bottom wall 4121 of the second insulation sublayer 412 is fastened to the bottom wall 4111 of the first insulation sublayer 411 and the side wall 4112 of the first insulation sublayer 411. The side wall 4122 of the second insulation sublayer 412 is fastened to the side wall 4112 of the first insulation sublayer 411.

It may be understood that the bottom wall 4111 of the first insulation sublayer 411 and the bottom wall 4121 of the second insulation sublayer 412 form a bottom wall of the insulation layer 41. The side wall 4112 of the first insulation sublayer 411 and the side wall 4122 of the second insulation sublayer 412 form a side wall of the insulation layer 41. The bottom wall of the insulation layer 41 and the side wall of the insulation layer 41 form a first accommodation space, and the second space 4123 forms the first accommodation space.

A bottom surface of the bottom wall 4111 of the first insulation sublayer 411 forms a bottom surface of the insulation layer 41. A top surface of the side wall of the insulation layer 41 (that is, a top surface of the side wall 4112 of the first insulation sublayer 411 and a top surface of the side wall 4122 of the second insulation sublayer 412) forms a top surface of the insulation layer 41. The bottom surface of the bottom wall 4111 of the first insulation sublayer 411 is a surface that is of the bottom wall 4111 and that faces the drive backplane 10. The top surface of the side wall 4112 of the first insulation sublayer 411 is a surface that is of the side wall 4112 and that faces away from the drive backplane 10. The top surface of the side wall 4122 of the second insulation sublayer 412 is a surface that is of the side wall 4122 and that faces away from the drive backplane 10. The top surface of the insulation layer 41 faces away from the drive backplane 10.

As shown in FIG. 4, the first insulation sublayer 411 may be configured to implement insulation between adjacent pixel structures 30, insulation between the drive backplane 10 and a light shielding layer 42, and insulation between the pixel structures 30 and the light shielding layer 42. In addition, the first insulation sublayer 411 may further repair the side surface 313 of the pixel structure 30.

As shown in FIG. 4, the second insulation sublayer 412 may be configured to fill the first space 4113 of the first insulation sublayer 411. In this way, thickness of the insulation layer 41 can be increased, and insulation effect can be enhanced.

In some implementations, a material of the first insulation sublayer 411 may be non-silicon oxide or non-silicon nitride. A material of the second insulation sublayer 412 may be silicon oxide or silicon nitride.

For example, the material of the first insulation sublayer 411 may include aluminum oxide (Al₂O₃), aluminum nitride (AlN), zirconia trioxide (ZrO₃), hafnium dioxide (HfO₂), titanium dioxide (TiO₂), silicon oxynitride (SiON), and zinc dioxide (ZnO₂). The material of the second insulation sublayer 412 may include silicon dioxide (SiO₂), silicon nitride (SiNₓ), and the like.

In another implementation, the material of the first insulation sublayer 411 may further include silicon dioxide (SiO₂), silicon nitride (SiNx), and the like. The material of the second insulation sublayer 412 may further include one or more of aluminum oxide (Al₂O₃), aluminum nitride (AlN), zirconia trioxide (ZrO₃), hafnium dioxide (HfO₂), titanium dioxide (TiO₂), silicon oxynitride (SiON), and zinc dioxide (ZnO₂).

In some implementations, the first insulation sublayer 411 may be prepared by using an atomic layer deposition (atomic layer deposition, ALD) process. It may be understood that, in a process of preparing the display panel 100 whose size is less than or equal to 0.5 inch and whose pixel density is greater than or equal to 4000 PPI, when the first insulation sublayer 411 is prepared by using the atomic layer deposition process, density of the first insulation sublayer 411 is good, and the first insulation sublayer 411 can fit the side surface 313 of the pixel structure 30 and cover the surface of the drive backplane 10, so that the insulation effect is good.

In another implementation, the first insulation sublayer 411 may alternatively be prepared through plasma enhanced chemical vapor deposition (plasma enhanced chemical vapor deposition, PECVD) or inductively coupled plasma chemical vapor deposition (Inductively Coupled Plasma Chemical Vapor Deposition, ICPCVD).

In some implementations, thickness of the bottom wall 4111 and the side wall 4112 of the first insulation sublayer 411 is greater than or equal to 5 nanometers and less than or equal to 50 nanometers. The thickness of the bottom wall 4111 of the first insulation sublayer 411 is thickness in a direction perpendicular to the drive backplane 10. The thickness of the side wall 4112 of the first insulation sublayer 411 is thickness in a direction perpendicular to the side wall 4112. In another implementation, the thickness of the bottom wall 4111 and the side wall 4112 of the first insulation sublayer 411 may alternatively be greater than or equal to 50 nanometers, or less than 5 nanometers.

In some implementations, the second insulation sublayer 412 may be prepared through plasma enhanced chemical vapor deposition (plasma enhanced chemical vapor deposition, PECVD). It may be understood that, a preparation speed of preparing the second insulation sublayer 412 by using the PECVD process is fast, which helps improve a processing speed. In another implementation, the second insulation sublayer 412 may alternatively be prepared by using an atomic layer deposition (Atomic layer deposition, ALD) process or through inductively coupled plasma chemical vapor deposition (Inductively Coupled Plasma Chemical Vapor Deposition, ICPCVD).

In some implementations, the thickness of the bottom wall 4121 and the side wall 4122 of the second insulation sublayer 412 is greater than or equal to 5 nanometers and less than or equal to 500 nanometers. The thickness of the bottom wall 4121 of the second insulation sublayer 412 is thickness in a direction perpendicular to the drive backplane 10. The thickness of the side wall 4122 of the second insulation sublayer 412 is thickness in a direction parallel to the drive backplane 10. In another implementation, the thickness of the bottom wall and the side wall of the second insulation sublayer 412 may alternatively be greater than or equal to 500 nanometers, or less than 5 nanometers.

As shown in FIG. 3 and FIG. 4, the filling layer 40 includes a first light shielding sublayer 421 and a second light shielding sublayer 428 that are stacked. The second light shielding sublayer 428 is located on a side that is of the first light shielding sublayer 421 and that is away from the drive backplane 10. The first light shielding sublayer 421 and the second light shielding sublayer 428 form the light shielding layer 42 of the filling layer 40. In another implementation, the light shielding layer 42 of the filling layer 40 may alternatively be of another structure.

For example, the first light shielding sublayer 421 is fastened to the second insulation sublayer 412, and is located in the second space 4123 of the second insulation sublayer 412.

For example, the first light shielding sublayer 421 includes a bottom wall 4211 and a side wall 4212 (the bottom wall 4211 and the side wall 4212 are schematically distinguished by using dashed lines in FIG. 4). The bottom wall 4211 and the side wall 4212 of the first light shielding sublayer 421 form third space 4213. The bottom wall 4211 of the first light shielding sublayer 421 is fastened to the bottom wall 4121 and the side wall 4122 of the second insulation sublayer 412, and the side wall 4212 of the first light shielding sublayer 421 is fastened to the side wall 4122 of the second insulation sublayer 412.

It may be understood that a relative location between the light shielding layer 42 and the light emitting layer 315 may be controlled by controlling the thickness of the second insulation sublayer 412.

For example, the second light shielding sublayer 428 is fastened to the first light shielding sublayer 421, and is disposed in the third space 4213 including the first light shielding sublayer 421.

For example, the second light shielding sublayer 428 includes a bottom wall 4281 and a side wall 4282 (the bottom wall 4281 and the side wall 4282 are schematically distinguished by using dashed lines in FIG. 4). The bottom wall 4281 and the side wall 4282 of the second light shielding sublayer 428 form fourth space 4283. The bottom wall 4281 of the second light shielding sublayer 428 is fastened to the bottom wall 4211 and the side wall 4212 of the first light shielding sublayer 421, and the side wall 4282 of the second light shielding sublayer 428 is fastened to the side wall 4212 of the first light shielding sublayer 421.

It may be understood that the bottom wall 4211 of the first light shielding sublayer 421 and the bottom wall 4281 of the second light shielding sublayer 428 form a bottom wall of the light shielding layer 42. The side wall 4212 of the first light shielding sublayer 421 and the side wall 4282 of the second light shielding sublayer 428 form a side wall of the light shielding layer 42. The bottom wall of the light shielding layer 42 and the side wall of the light shielding layer 42 form second accommodation space, and the fourth space forms the second accommodation space.

A bottom surface of the bottom wall 4211 of the first light shielding sublayer 421 forms the bottom surface 424 of the light shielding layer 42. The bottom surface of the bottom wall 4211 of the first light shielding sublayer 421 is a surface that is of the bottom wall 4211 and that faces the drive backplane 10. A top surface of the side wall of the light shielding layer 42 (that is, a top surface of the side wall 4122 of the first light shielding sublayer 421 and a top surface of the side wall 4282 of the second light shielding sublayer 428) is a top surface 423 of the light shielding layer 42. The top surface of the side wall 4122 of the first light shielding sublayer 421 is a surface that is of the side wall 4122 and that faces away from the drive backplane 10. The top surface of the side wall 4282 of the second light shielding sublayer 428 is a surface that is of the side wall 4282 and that faces away from the drive backplane 10. Therefore, the top surface 423 of the light shielding layer 42 faces away from the drive backplane 10.

As shown in FIG. 3, both the first light shielding sublayer 421 and the second light shielding sublayer 428 may be configured to shield light emitted from the side surface 313 of the pixel structure 30.

As shown in FIG. 3 and FIG. 4, the bottom surface 424 of the light shielding layer 42 is fastened to the insulation layer 41, and the top surface 423 of the light shielding layer 42 faces away from the bottom wall of the insulation layer 41. In the thickness direction of the display panel 100, a distance between the bottom surface 424 of the light shielding layer 42 (that is, a surface that is of the bottom wall 4211 of the first light shielding sublayer 421 and that is close to the drive backplane 10) and the drive backplane 10 is less than or equal to a distance between the bottom surface 3152 of the light emitting layer 315 and the drive backplane 10. A distance between the top surface 423 of the light shielding layer 42 (that is, the top surface of the side wall 4212 of the first light shielding sublayer 421 and the top surface of the side wall 4282 of the second light shielding sublayer 428) and the drive backplane 10 is greater than or equal to a distance between the top surface 3151 of the light emitting layer 315 and the drive backplane 10.

It may be understood that an orthographic projection of the light emitting layer 315 on the light shielding layer 42 is located on the light shielding layer 42. In other words, thickness of the side wall of the light shielding layer 42 including the first light shielding sublayer 421 and the second light shielding sublayer 428 is greater than or equal to thickness of the light emitting layer 315, the light shielding layer 42 is disposed opposite to the light emitting layer 315, and the light emitted from the side surface 313 of the pixel structure may be mostly shielded by the light shielding layer 42.

In another implementation, the distance between the bottom surface 424 of the light shielding layer 42 (that is, the surface that is of the bottom wall 4211 of the first light shielding sublayer 421 and that is close to the drive backplane 10) and the drive backplane 10 may alternatively be greater than the distance between the bottom surface 3152 of the light emitting layer 315 and the drive backplane 10. Alternatively, the distance between the top surface 423 of the light shielding layer 42 (that is, the top surface of the side wall 4212 of the first light shielding sublayer 421 and the top surface of the side wall 4282 of the second light shielding sublayer 428) and the drive backplane 10 may alternatively be less than the distance between the top surface 3151 of the light emitting layer 315 and the drive backplane 10.

As shown in FIG. 3 and FIG. 4, the light shielding layer 42 shields the light emitted from the side surface 313 of the pixel structure 30 in two manners: absorption and reflection. It may be understood that, for light shielding layers 42 of different materials, absorption and reflection proportions that are of the light shielding layers 42 and that are obtained when the light shielding layers 42 shield light are also different.

For example, the material of the light shielding layer 42 may be a material with high visible light reflectivity. It can be understood that the material with high visible reflectivity is a material whose reflectivity to visible light is greater than absorption to visible light. The light shielding layer 42 is prepared by using the material with high visible light reflectivity. Most of the light emitted from the side surface 313 of the pixel structure 30 may be reflected back to the pixel structure 30 by the light shielding layer 42, and then is emitted from the top surface 311 of the pixel structure 30 to be received by the user. In other words, the light emitted from the side surface 313 of the pixel structure 30 is received by the user as much as possible, instead of being absorbed by the light shielding layer 42. This reduces an energy loss. In another implementation, the material of the light shielding layer 42 may alternatively be a material with low visible light reflectivity. In addition, a refractive index of the insulation layer 41 (including the first insulation sublayer 411 and the second insulation sublayer 412) may be changed, so that light reflected by the light shielding layer 42 is emitted from the top surface 311 of the pixel structure 30 as much as possible to be received by the user. A quantity of light reflection and refraction times is reduced to reduce the energy loss.

For example, the material of the light shielding layer 42 may be a metal material with high visible light reflectivity. In this way, the light shielding layer 42 can reflect the light emitted from the pixel structure 30, to avoid the optical crosstalk between two adjacent pixel structures 30, that is, light emitted from a side surface 313 of one pixel structure 30 is not easily propagated to the other pixel structure 30. In addition, the light shielding layer 42 may be further configured to assist the pixel structure 30 in heat dissipation while shielding light. The material of the light shielding layer 42 may include one or more of metal chromium (Cr), metal silver (Ag), metal aluminum (Al), and metal titanium (Ti).

For example, the material of the light shielding layer 42 may be a metal material whose visible light reflectivity is greater than or equal to 80%, for example, may be metal aluminum (Al) or metal silver (Ag).

It may be understood that, when the light shielding layer 42 includes a plurality of light shielding sublayers, at least one of the plurality of light shielding sublayers is a metal material whose visible light reflectivity is greater than or equal to 80%. For example, the first light shielding sublayer 421 or the second light shielding sublayer 428 may be a metal material whose visible light reflectivity is greater than or equal to 80%. Alternatively, both the first light shielding sublayer 421 and the second light shielding sublayer 428 are metal materials whose visible light reflectivity is greater than or equal to 80%.

In some implementations, materials of the first light shielding sublayer 421 and the second light shielding sublayer 428 may include one or more of metal chromium (Cr), metal silver (Ag), metal aluminum (Al), and metal titanium (Ti). The material of the second light shielding sublayer 428 may be the same as or different from that of the first light shielding sublayer 421.

In some implementations, the material of the second light shielding sublayer 428 is different from the material of the first light shielding sublayer 421. The first light shielding sublayer 421 may use a material with good bonding performance with both the second insulation sublayer 412 and the second light shielding sublayer 428, and adhesion between the first light shielding sublayer 421 and the insulation layer 41 (the second insulation sublayer 412) is greater than adhesion between the second light shielding sublayer 428 and the insulation layer 41 (the second insulation sublayer 412). In this way, in addition to shielding the light emitted from the side surface 313 of the pixel structure 30, the first light shielding sublayer 421 may be further configured to enhance a connection between the second light shielding sublayer 428 and the second insulation sublayer 412, to reduce a risk of falling off of the second light shielding sublayer 428. The second light shielding sublayer 428 may be configured to shield the light emitted from the side surface 313 of the pixel structure 30.

For example, the material of the first light shielding sublayer 421 is metal chromium (Cr), and the material of the second light shielding sublayer 428 is metal aluminum (Al).

A preparation process of the first light shielding sublayer 421 and the second light shielding sublayer 428 may be an electron beam evaporation (electron beam evaporation, ebeam) process, a metal sputter (sputter) process, or the like. The preparation process of the first light shielding sublayer 421 may be the same as or different from the preparation process of the second light shielding sublayer 428. This is not limited in this application.

In some implementations, the thickness of the bottom wall 4211 and the side wall 4212 of the first light shielding sublayer 421 may be greater than or equal to 1 nanometer and less than or equal to 100 nanometers. The thickness of the bottom wall 4211 of the first light shielding sublayer 421 is thickness in the direction perpendicular to the drive backplane 10. The thickness of the side wall 4212 of the first light shielding sublayer 421 is thickness in the direction parallel to the drive backplane 10. In another implementation, the thickness of the bottom wall 4211 and the side wall 4212 of the first light shielding sublayer 421 may alternatively be greater than or equal to 100 nanometers.

In some implementations, the thickness of the bottom wall 4281 and the side wall 4282 of the second light shielding sublayer 428 is greater than or equal to 100 nanometers and less than or equal to 2000 nanometers. In another implementation, the thickness of the bottom wall 4281 and the side wall 4282 of the second light shielding sublayer 428 may alternatively be greater than 2000 nanometers, or less than 100 nanometers.

As shown in FIG. 3 and FIG. 4, the filling layer 40 further includes a dielectric layer 90. The dielectric layer 90 is located on a side that is of the light shielding layer 42 and that is away from the drive backplane 10.

For example, the dielectric layer 90 is fastened to the second light shielding sublayer 428, and is located in fourth space 4283 of the second light shielding sublayer 428. The dielectric layer 90 is insulated from the second light shielding sublayer 428. The dielectric layer 90 includes a top surface 91 and a bottom surface 92 that are disposed away from each other. The bottom surface 92 of the dielectric layer 90 is fastened to the bottom wall 4281 of the second light shielding sublayer 428. The top surface 91 of the dielectric layer 90 faces away from the drive backplane 10.

It may be understood that, in comparison with a solution in which only the light shielding layer 42 fills the first accommodation space, a solution in which the first accommodation space is filled through cooperation between the light shielding layer 42 with the metal material and the dielectric layer 90 reduces thickness of the bottom wall 4281 of the second light shielding sublayer 428 in the direction perpendicular to the drive backplane 10, and reduces a risk of a short circuit of the light shielding layer 42.

A material of the dielectric layer 90 may include silicon dioxide (SiO₂), silicon nitride (SiNₓ), silicon oxynitride (SiON), aluminum oxide (Al₂O₃), zirconium trioxide (ZrO₃), hafnium dioxide (HfO₂), titanium dioxide (TiO₂), aluminum nitride (AlN), dizinc oxide (ZnO₂), and the like.

The top surface 91 of the dielectric layer 90, the top surface 423 of the light shielding layer 42, and the top surface of the insulation layer 41 form the top surface 43 of the filling layer 40. The top surface 311 of the pixel structure 30 is flush with the top surface 43 of the filling layer 40, that is, the top surface 91 of the dielectric layer 90, the top surface 423 of the light shielding layer 42, and the top surface of the insulation layer 41 are flush with the top surface 311 of the pixel structure 30. It may be understood that the material of the dielectric layer 90 is easier to process than that of the light shielding layer 42, to facilitate a flattening process.

In another implementation, the filling layer 40 may not include the dielectric layer 90, and the top surface 423 of the light shielding layer 42 and the top surface of the insulation layer 41 form the top surface 43 of the filling layer 40.

A preparation process of the dielectric layer 90 may be an atomic layer deposition (atomic layer deposition, ALD) process or plasma enhanced chemical vapor deposition (plasma enhanced chemical vapor deposition, PECVD).

Thickness of the dielectric layer 90 in the direction perpendicular to the drive backplane 10 is greater than or equal to 100 nanometers and less than or equal to 2000 nanometers. In another implementation, the thickness of the dielectric layer 90 may alternatively be greater than or equal to 2000 nanometers, or less than 100 nanometers.

As shown in FIG. 3 and FIG. 4, the conducting layer 50 is fastened to the top surface 311 of the pixel structure 30 and the top surface 43 of the filling layer 40. Both the top surface 43 of the filling layer 40 and the top surface 311 of the pixel structure 30 face away from the drive backplane 10. It may be understood that the filling layer 40 may further provide support for the conducting layer 50.

For example, the conducting layer 50 is fastened to the pixel structure 30 and the filling layer 40. Specifically, the conducting layer 50 is fastened to the pixel structure 30, the side wall 4112 of the first insulation sublayer 411, the side wall 4122 of the second insulation sublayer 412, the side wall 4212 of the first light shielding sublayer 421, the second light shielding sublayer 428, and the dielectric layer 90.

A material of the conducting layer 50 may be a transparent conducting material. It may be understood that the conducting layer 50 is located on a side that is of the pixel structure 30 and that is away from the drive backplane 10, and the conducting layer 50 is made of a transparent material, and does not shield light diverged by the pixel structure 30. In addition, the conducting layer 50 uses a conducting material, so that the conducting layer 50 is electrically connected to the pixel structure 30. When the drive backplane 10 applies a current to the pixel structure 30, the conducting layer 50 assists in diffusing the current, so that the current is quickly diffused to the pixel structures 30 of the entire display panel 100, to improve light emission uniformity of the display panel 100. When the material of the light shielding layer 42 is the metal material, the light shielding layer 42 is electrically connected to the conducting layer 50, and the light shielding layer 42 may also help the conducting layer transfer an electrical signal.

For example, a material of the conducting layer 50 may include one or more of indium tin oxide (indium tin oxide, ITO), indium zinc oxide (indium zinc oxide, IZO), aluminum-doped zinc oxide (aluminum-doped zinc oxide, AZO), and fluorine-doped tin oxide (fluorine-doped tin oxide, FTO).

In some implementations, thickness of the conducting layer 50 in the direction perpendicular to the drive backplane 10 is greater than or equal to 10 nanometers and less than or equal to 500 nanometers. In another implementation, the thickness of the conducting layer 50 in the direction perpendicular to the drive backplane 10 may alternatively be less than 10 nanometers or greater than 500 nanometers.

As shown in FIG. 3 and FIG. 4, the microlens 60 is fastened to a surface that is of the conducting layer and that is away from the pixel structure 30.

For example, there are a plurality of microlenses 60. A quantity of microlenses 60 may be the same as a quantity of pixel structures 30. The plurality of microlenses 60 are disposed opposite to the plurality of pixel structures 30 in a one-to-one correspondence.

The microlens 60 may be configured to converge light emitted from the pixel structure 30. The microlens 60 may be a lens with a refractive power. For example, the microlens 60 may be a spheric lens. The microlens 60 may alternatively be an aspheric lens.

In another implementation, the microlens 60 may alternatively be of a hemispherical structure. The microlens 60 may alternatively be an ellipsoidal structure, a columnar structure, or a structure with a trapezoidal cross section (for example, a circular truncated cone structure). There may alternatively be one microlens 60. This is not limited in this application.

As shown in FIG. 3, the filling layer 40 is disposed between two adjacent pixel structures 30, and the filling layer 40 includes the insulation layer 41 and the light shielding layer 42. Therefore, insulation protection is performed on the two adjacent pixel structures 30 through the insulation layer 41, and the light emitted from the side surface 313 of the pixel structure 30 is shielded through the light shielding layer 42. This avoids the optical crosstalk between the two adjacent pixel structures 30, that is, light emitted from the side surface 313 of one pixel structure 30 is not easily propagated to the other pixel structure 30. In particular, when the display panel 100 displays a frame of picture, if one of two adjacent pixel structures 30 needs to emit light and the other does not emit light, light from the pixel structure 30 that is emitting light is not prone to crosstalk to the pixel structure 30 that does not emit light.

In addition, the size of the display panel 100 is less than or equal to 0.5 inch, so that the display panel 100 with a small size and light mass is obtained. In this way, the display panel 100 requires small mounting space, and a limitation on a mounting location of the display panel 100 is small. This facilitates mounting of the display panel 100. In addition, because the display panel 100 is light in mass, when the display panel 100 is applied to the electronic device 1000, the electronic device 1000 can be implemented to be lightweight, to improve user experience.

As the size of the display panel becomes smaller, a pitch between two adjacent pixel structures becomes smaller. In this case, the optical crosstalk between two adjacent pixel structures becomes increasingly severe. Therefore, for a miniaturized and lightweight display panel 100, optical crosstalk is severe, and display quality is poor. The filling layer 40 is disposed between two adjacent pixel structures 30, the filling layer 40 includes the insulation layer 41 and the light shielding layer 42, and the light emitted from the side surface of the pixel structure 30 is shielded by the light shielding layer 42, so that the optical crosstalk between the two adjacent pixel structures 30 is avoided, and the optical crosstalk of the miniaturized and lightweight display panel 100 is resolved to a great extent.

Therefore, the filling layer 40 is disposed between two adjacent pixel structures 30, so that good display quality is ensured while the display panel 100 is implemented to be miniaturized and lightweight. In other words, optical crosstalk is not prone to occurring in two adjacent pixel structures 30.

The foregoing specifically describes an implementation of the display panel 100 with reference to related accompanying drawings. The following specifically describes a preparation method of the display panel 100 in the foregoing implementation with reference to related accompanying drawings.

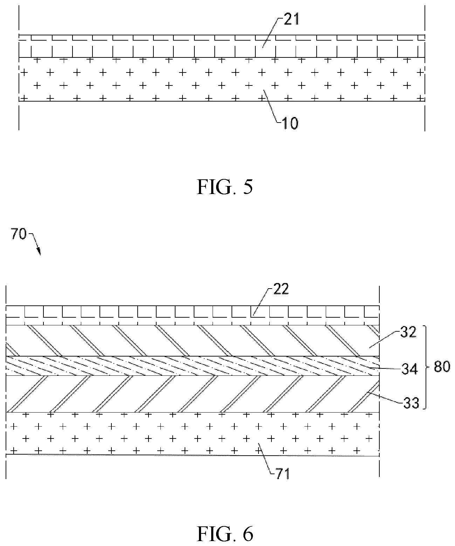

FIG. 5 to FIG. 20 are partial sectional views of some corresponding preparation steps in the preparation method of the display panel 100. As shown in FIG. 5 to FIG. 20, the preparation method of the display panel 100 provided in some implementations includes the following steps.

Step 1: As shown in FIG. 5, form a first bonding substructure 21 on a surface of a drive backplane 10.

Step 2: As shown in FIG. 6, sequentially form a to-be-processed pixel layer 80 and a second bonding substructure 22 on a surface of an epitaxial wafer substrate 71, to form an epitaxial backplane 70. The to-be-processed pixel layer 80 is located between the second bonding substructure 22 and the epitaxial wafer substrate 71.

For example, the to-be-processed pixel layer 80 includes a to-be-processed first semiconductor layer 32, a to-be-processed second semiconductor layer 33, and a to-be-processed light emitting layer 34. The second bonding substructure 22 is fastened to the to-be-processed first semiconductor layer 32. The to-be-processed second semiconductor layer 33 is fastened to the epitaxial wafer substrate 71. The to-be-processed light emitting layer 34 is located between the to-be-processed first semiconductor layer 32 and the to-be-processed second semiconductor layer 33.

It should be noted that step 1 and step 2 may be simultaneously performed, to reduce processing duration.

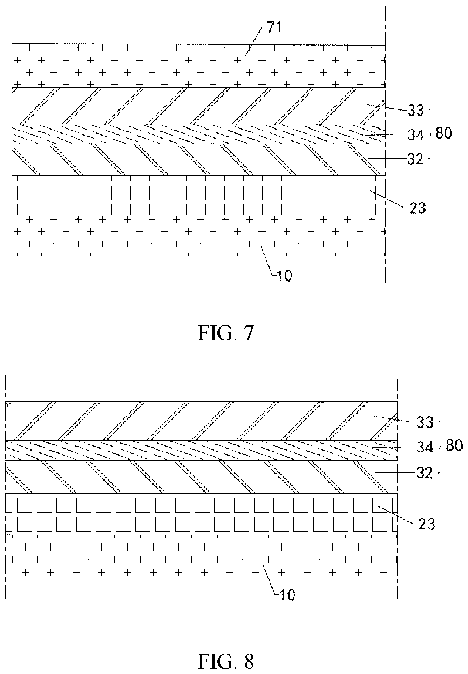

Step 3: As shown in FIG. 7, bond the drive backplane 10 and the epitaxial backplane 70. The first bonding substructure 21 and the second bonding substructure 22 form a to-be-processed bonding structure 23. The to-be-processed pixel layer 80 is located on a side that is of the to-be-processed bonding structure 23 and that is away from the drive backplane 10.

Step 4: As shown in FIG. 8, remove the epitaxial wafer substrate 71.

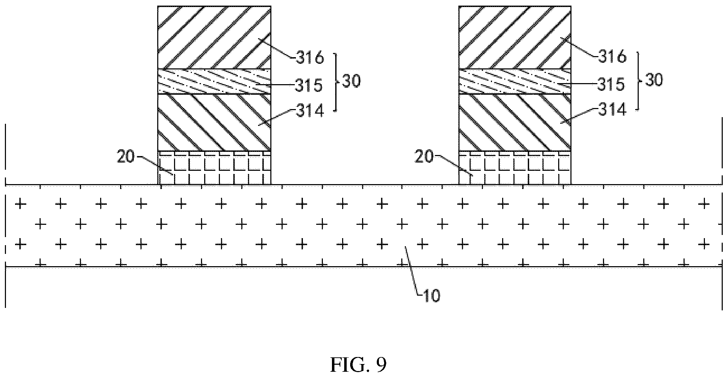

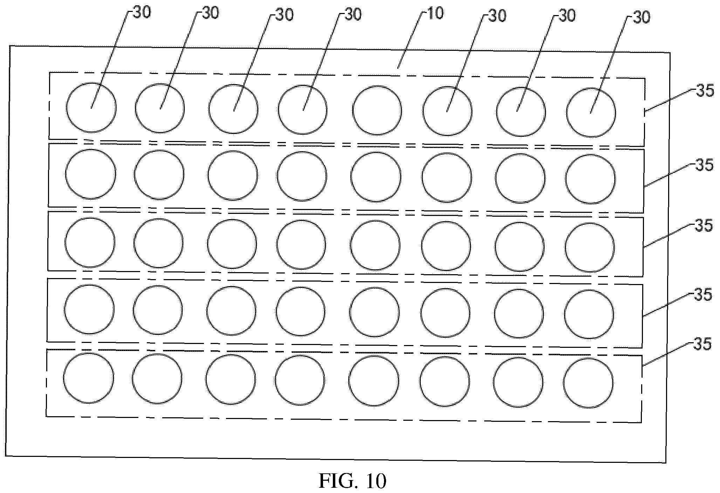

Step 5: As shown in FIG. 9 and FIG. 10, FIG. 10 being a top view of FIG. 9, etch the to-be-processed pixel layer 80 and the to-be-processed bonding structure 23 to form a plurality of pixel structures 30 and bonding structures 20 that are arranged at intervals, where the bonding structure 20 is located between the drive backplane 10 and the pixel structure 30.

For example, the to-be-processed pixel layer 80 and the to-be-processed bonding structure 23 are etched, and the plurality of pixel structures 30 and bonding structures 20 that are arranged at intervals are formed through exposure and development. The pixel structure 30 includes a first semiconductor layer 314, a light emitting layer 315, and a second semiconductor layer 316 that are stacked. Between the light emitting layer 315, and the first semiconductor layer 314 and the second semiconductor layer 316, the first semiconductor layer 314 is located on the bonding structure 20, and the second semiconductor layer 316 is located on a side that is of the light emitting layer 315 and that is away from the drive backplane 10.

As shown in FIG. 10, the plurality of pixel structures 30 are arranged at intervals on a surface of the drive backplane 10 in a first direction, to form pixel groups 35. The plurality of pixel groups 35 are arranged at intervals in a second direction. The first direction and the second direction are set at an included angle. In any pixel group, an interval between adjacent pixel structures 30 in the second direction is less than or equal to 2 micrometers. In addition, in the second direction, an interval between adjacent pixel groups is less than or equal to 2 micrometers.

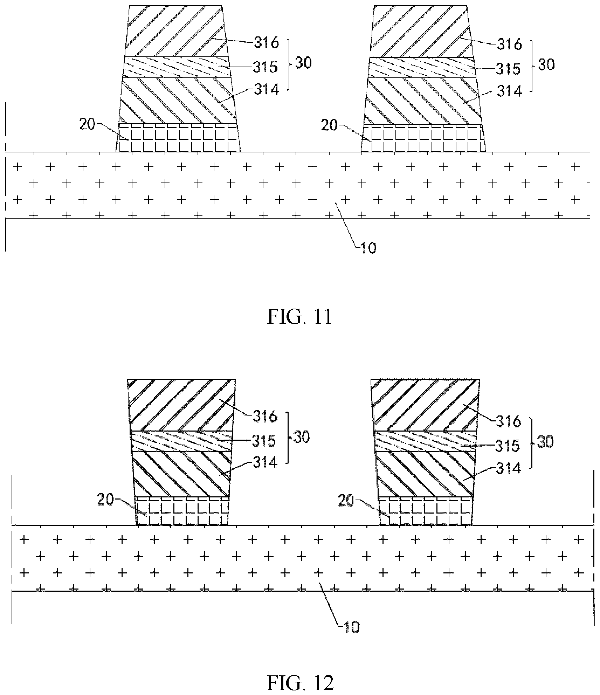

A height of the pixel structure 30 in a direction perpendicular to the drive backplane 10 is less than or equal to 2 micrometers. The pixel structure 30 may be a cylindrical structure with a cross section being a rectangle shown in FIG. 9, and a height of the rectangle is less than or equal to 2 micrometers. In another implementation, the pixel structure 30 may alternatively be a circular truncated cone structure. A cross section of the pixel structure 30 may be a regular trapezoid (as shown in FIG. 11), or may be an inverted trapezoid (as shown in FIG. 12). A specific shape of the pixel structure 30 is not limited in this application.

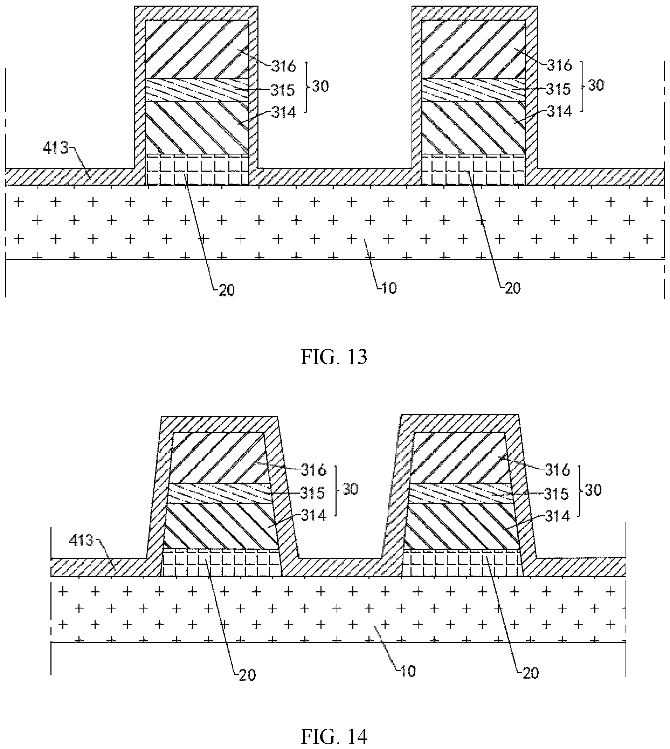

Step 6: As shown in FIG. 13 and FIG. 14, deposit a to-be-processed first insulation sublayer 413 by using a conformal thin film deposition process. The to-be-processed first insulation sublayer 413 covers the pixel structures 30 and the bonding structures 20. The to-be-processed first insulation sublayer 413 is connected to the pixel structures 30, the bonding structures 20, and the drive backplane 10.

It may be understood that the conformal thin film deposition process has a good graphic covering capability. In a preparation process of the display panel 100 whose size is less than or equal to 0.5 inch and whose pixel density is greater than or equal to 4000 PPI, the conformal thin film deposition process can be used to form good wrapping (as shown in FIG. 13 and FIG. 14) on pixel structures 30 in different shapes. This reduces a probability that a gap occurs between the to-be-processed first insulation sublayer 413 and each of the pixel structure 30, the bonding structure 20, and the drive backplane 10.

The conformal thin film deposition process may be an atomic layer deposition (Atomic layer deposition, ALD) process, a plasma enhanced chemical vapor deposition (plasma enhanced chemical vapor deposition, PECVD) process, an inductively coupled plasma chemical vapor deposition (Inductively Coupled Plasma Chemical Vapor Deposition, ICPCVD) process, an electron beam evaporation (Electron Beam Evaporation, ebeam) process, or metal sputter (sputter). It may be understood that an appropriate conformal thin film deposition process may be selected based on a material that needs to be deposited.

For example, the to-be-processed first insulation sublayer 413 is deposited by using the atomic layer deposition (Atomic layer deposition, ALD) process.

Deposition thickness of the to-be-processed first insulation sublayer 413 is greater than or equal to 5 nanometers and less than or equal to 50 nanometers. A material of the to-be-processed first insulation sublayer 413 may be an aluminum-containing compound, for example, aluminum oxide (Al₂O₃) or aluminum nitride (AlN).

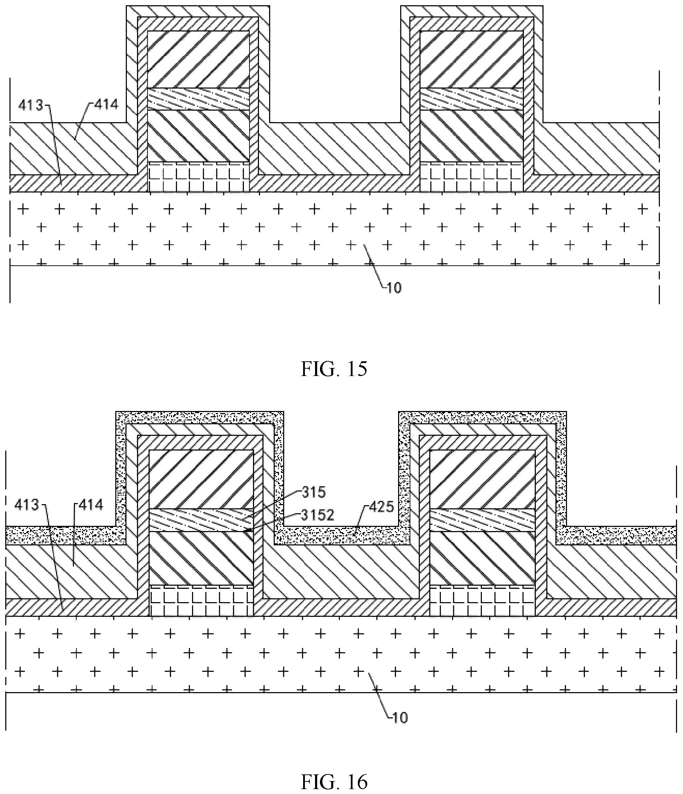

Step 7: As shown in FIG. 15, deposit a to-be-processed second insulation sublayer 414 on a side that is of the to-be-processed first insulation sublayer 413 and that is away from the drive backplane 10 by using the conformal thin film deposition process.

For example, the to-be-processed second insulation sublayer 414 is deposited through plasma enhanced chemical vapor deposition (plasma enhanced chemical vapor deposition, PECVD). Deposition thickness of the to-be-processed second insulation sublayer 414 is greater than or equal to 5 nanometers and less than or equal to 500 nanometers. A material of the to-be-processed second insulation sublayer 414 may be a silicon-containing compound, for example, silicon dioxide (SiO₂), silicon nitride (SiNx), or silicon oxynitride (SiON).

Step 8: As shown in FIG. 16, deposit a to-be-processed first light shielding sublayer 425 on a side that is of the to-be-processed second insulation sublayer 414 and that is away from the drive backplane 10 by using the conformal thin film deposition process. A deposition start location of the to-be-processed first light shielding sublayer 425 is lower than or flush with a bottom surface 3152 of the light emitting layer 315.

For example, the deposition start location of the to-be-processed first light shielding sublayer 425 is lower than the bottom surface 3152 of the light emitting layer 315.

The to-be-processed first light shielding sublayer 425 is deposited by using the electron beam evaporation (electron beam evaporation, ebeam) process or metal sputter (sputter). Deposition thickness of the to-be-processed first light shielding sublayer 425 is greater than or equal to 1 nanometer and less than or equal to 100 nanometers. A material of the to-be-processed first light shielding sublayer 425 is metal chromium (Cr).

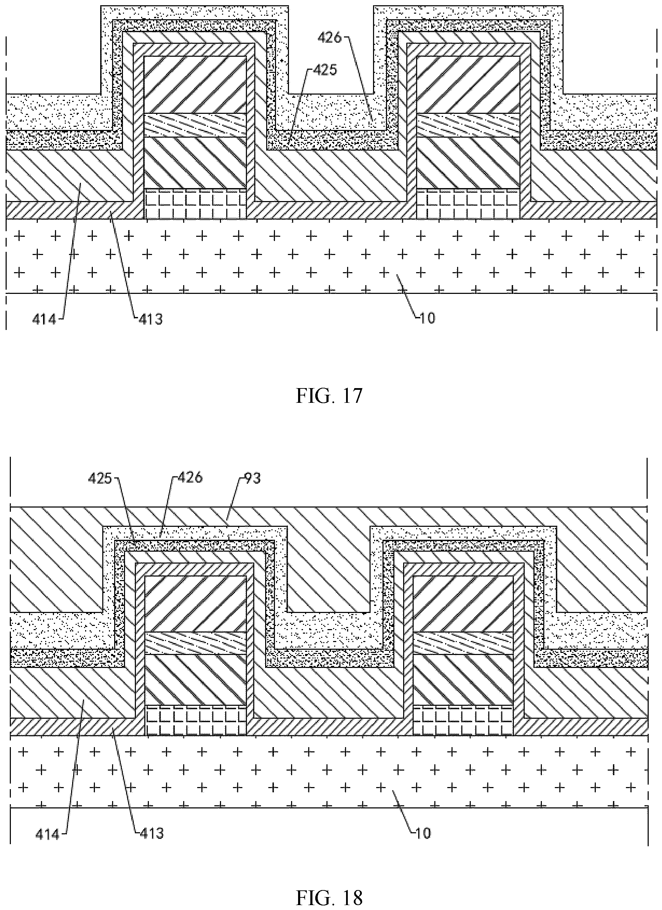

Step 9: As shown in FIG. 17, deposit a to-be-processed second light shielding sublayer 426 on a side that is of the to-be-processed first light shielding sublayer 425 and that is away from the drive backplane 10 by using the conformal thin film deposition process.

For example, the to-be-processed second light shielding sublayer 426 is deposited by using the electron beam evaporation (electron beam evaporation, ebeam) process or metal sputter (sputter). Deposition thickness of the to-be-processed second light shielding sublayer 426 is greater than or equal to 100 nanometers and less than or equal to 2000 nanometers. A material of the to-be-processed second light shielding sublayer 426 may be metal silver (Ag) or metal aluminum (Al).

Step 10: As shown in FIG. 18, deposit a to-be-processed dielectric layer 93 on a side that is of the to-be-processed second light shielding sublayer 426 and that is away from the drive backplane 10 by using the conformal thin film deposition process.

For example, the to-be-processed dielectric layer 93 is deposited by using the atomic layer deposition (atomic layer deposition, ALD) process or through plasma enhanced chemical vapor deposition (plasma enhanced chemical vapor deposition, PECVD).

Deposition thickness of the to-be-processed dielectric layer 93 is greater than or equal to 100 nanometers and less than or equal to 2000 nanometers. A material of the to-be-processed dielectric layer 93 may include silicon dioxide (SiO₂), silicon nitride (SiNₓ), silicon oxynitride (SiON), aluminum oxide (Al₂O₃), zirconium trioxide (ZrO₃), hafnium dioxide (HfO₂), titanium dioxide (TiO₂), aluminum nitride (AlN), dizinc oxide (ZnO₂), and the like.

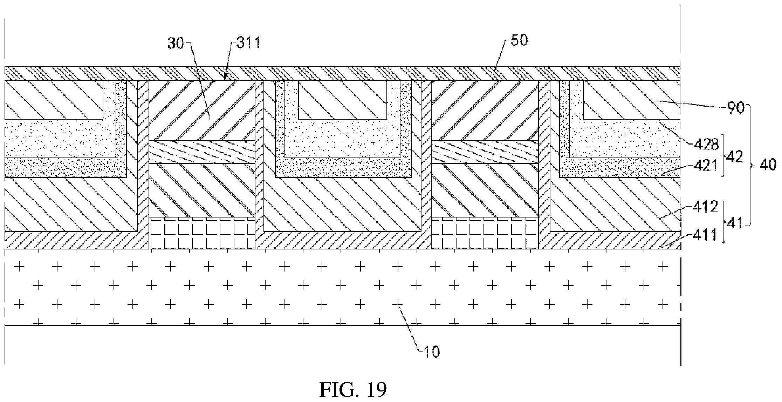

Step 11: As shown in FIG. 19, process the to-be-processed first insulation sublayer 413, the to-be-processed second insulation sublayer 414, the to-be-processed first light shielding sublayer 425, the to-be-processed second light shielding sublayer 426, and the to-be-processed dielectric layer 93, to form a first insulation sublayer 411, a second insulation sublayer 412, a first light shielding sublayer 421, a second light shielding sublayer 428, and a dielectric layer 90, where the first insulation sublayer 411 and the second insulation sublayer 412 form an insulation layer 41, the first light shielding sublayer 421 and the second light shielding sublayer 428 form a light shielding layer 42, and the insulation layer 41, the light shielding layer 42, and the dielectric layer 90 form a filling layer 40; and form a conducting layer 50 on a side that is of the pixel structure 30 and the filling layer 40 and that is away from the drive backplane 10.

For example, a surface that is of the filling layer 40 and that is away from the drive backplane 10 is flush with a top surface 311 of the pixel structure 30, and the top surface 311 of the pixel structure 30 is completely exposed. The conducting layer 50 covers the pixel structure 30 and the filling layer 40. To be specific, the conducting layer 50 is connected to the top surface 311 of the pixel structure 30, the first insulation sublayer 411, the second insulation sublayer 412, the first light shielding sublayer 421, the second light shielding sublayer 428, and the dielectric layer 90. Adhesion between the first light shielding sublayer 421 and the second insulation sublayer 412 is greater than adhesion between the second light shielding sublayer 428 and the second insulation sublayer 412.

A process for processing the to-be-processed first insulation sublayer 413, the to-be-processed second insulation sublayer 414, the to-be-processed first light shielding sublayer 425, the to-be-processed second insulation sublayer 414, and the to-be-processed dielectric layer 93 may be a photoresist reflow (photoresist reflow, PR) process or a chemical mechanical polishing (chemical mechanical polishing, CMP) process.

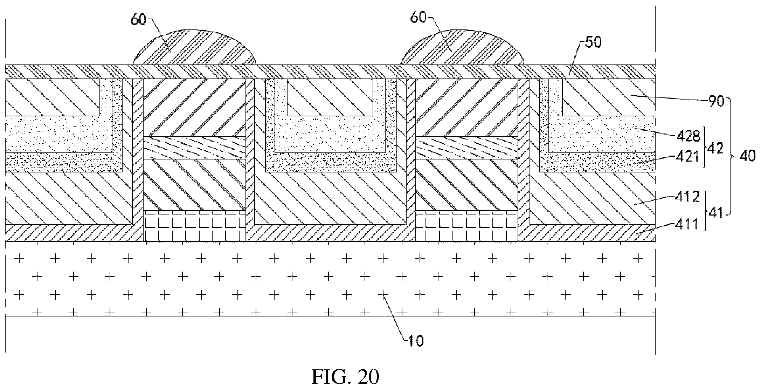

Step 12: Form a microlens 60 on a surface that is of the conducting layer 50 and that is away from the drive backplane 10, and finally form the display panel 100 shown in FIG. 20. FIG. 20 is a diagram of an implementation of the display panel 100 shown in FIG. 3.

For example, there are a plurality of microlenses 60. A quantity of pixel structures 30 is equal to a quantity of microlenses 60, and each pixel structure 30 corresponds to one microlens 60. The pixel structure 30 is disposed opposite to the corresponding microlens 60.

It may be understood that the filling layer 40 is disposed between the pixel structures 30 of the display panel 100 prepared in step 1 to step 12. The filling layer 40 includes the insulation layer 41, the light shielding layer 42, and the dielectric layer 90. In this way, insulation protection is performed on two adjacent pixel structures 30 through the insulation layer 41, and light emitted from a side surface 313 of the pixel structure 30 is shielded through the light shielding layer 42. This avoids optical crosstalk between the two adjacent pixel structures 30, that is, light emitted from the side surface 313 of one pixel structure 30 is not prone to being propagated to the other pixel structure 30. In particular, when the display panel 100 displays a frame of picture, if one of two adjacent pixel structures 30 needs to emit light and the other does not emit light, light from the pixel structure 30 that is emitting light is not prone to crosstalk to the pixel structure 30 that does not emit light. In addition, the dielectric layer 90 may be used to reduce the thickness of a bottom wall of the light shielding layer 42 in a direction perpendicular to the drive backplane 10, to reduce a risk of a short circuit of the light shielding layer 42.

The light shielding layer 42 uses a metal material whose reflectivity to visible light is higher than 80%. In this way, most of the light emitted from the side surface 313 of the pixel structure 30 is reflected back, so that the light can still be emitted from the top surface of the pixel structure 30. This avoids energy waste, and helps reduce energy consumption of the display panel 100. In addition, the light shielding layer 42 may further assist the pixel structure 30 in heat dissipation. In a running process of the display panel 100, the pixel structure 30 is not prone to being faulty due to overheating. This helps prolong a service life of the display panel 100.

In addition, in the preparation process of the display panel 100 whose size is less than or equal to 0.5 inch and whose pixel density is greater than or equal to 4000 PPI, the conformal thin film deposition process can be used to form good wrapping (as shown in FIG. 13 and FIG. 14) on pixel structures 30 in different shapes. This reduces the probability that the gap occurs between the to-be-processed first insulation sublayer 413 and each of the pixel structure 30, the bonding structure 20, and the drive backplane 10.

In addition, the first insulation sublayer 411 and the second insulation sublayer 412 are prepared by using different conformal thin film deposition processes, so that good filling effect is achieved while insulation effect is ensured. The first light shielding sublayer 421 and the second light shielding sublayer 428 are prepared by using different materials, where the material of the first light shielding sublayer 421 has good adhesion performance with both the second insulation sublayer 412 and the second light shielding sublayer 428. In this way, a risk of falling off of the second light shielding sublayer 428 can be reduced.

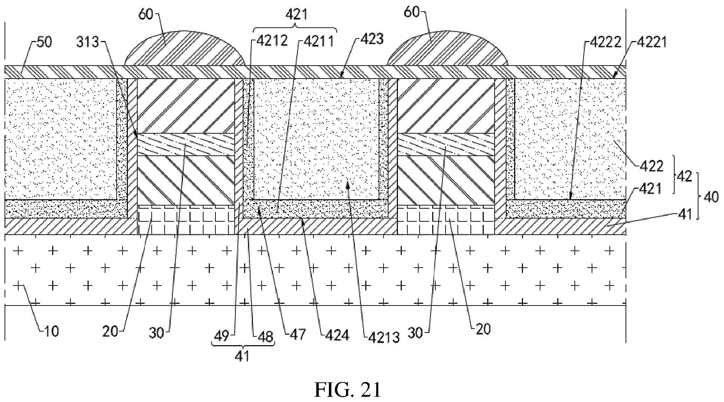

In some implementations, technical content that is the same as that of the display panel 100 (as shown in FIG. 3 and FIG. 4) in the foregoing implementations is not described again. FIG. 21 is a partial sectional view of another implementation of the display panel 100 shown in FIG. 2 at A-A.

As shown in FIG. 21, the filling layer 40 may include an insulation layer 41 and a light shielding layer 42. The light shielding layer 42 includes the first light shielding sublayer 421 and the second light shielding sublayer 422. In other words, the filling layer 40 may not include the dielectric layer 90. In addition, the insulation layer 41 includes only one layer, and is not layered.

For example, the insulation layer 41 includes a bottom wall 48 and a side wall 49 (the bottom wall 48 and the side wall 49 are schematically distinguished by using dashed lines in FIG. 21). The bottom wall 48 and the side wall 49 of the insulation layer 41 form first accommodation space 47. The bottom wall 48 is fastened to the drive backplane 10 and the bonding structure 20, and the side wall 49 is fastened to the pixel structure 30 and the bonding structure 20. In another implementation, the side wall 49 may alternatively be connected only to the pixel structure 30.

For example, the first light shielding sublayer 421 is fastened to the insulation layer 41, and the first light shielding sublayer 421 is located in the first accommodation space 47 of the insulation layer 41.

For example, the first light shielding sublayer 421 includes a bottom wall 4211 and a side wall 4212 (the bottom wall 4211 and the side wall 4212 are schematically distinguished by using dashed lines in FIG. 21). The bottom wall 4211 and the side wall 4212 of the first light shielding sublayer 421 form third space 4213. The bottom wall 4211 of the first light shielding sublayer 421 is fastened to the bottom wall 48 and the side wall 49 of the insulation layer 41, and the side wall 4212 of the first light shielding sublayer 421 is fastened to the side wall 49 of the insulation layer 41.

For example, the second light shielding sublayer 422 is fastened and connected to the first light shielding sublayer 421, and is located in the third space 4213 of the first light shielding sublayer 421. The second light shielding sublayer 422 includes a top surface 4221 and a bottom surface 4222 that are disposed away from each other. The bottom surface 4222 of the second light shielding sublayer 422 is fastened to the bottom wall 4211 of the first light shielding sublayer 421. The second light shielding sublayer 422 fills the third space 4213, that is, a spatial shape of the second light shielding sublayer 422 is basically consistent with a spatial shape of the third space 4213. Thickness of the second light shielding sublayer 422 in a thickness direction of the drive backplane 10 is equal to a depth of the third space 4213 in the thickness direction of the drive backplane 10. It should be noted that the thickness of the light shielding layer 421 is not absolutely equal to the depth of the third space 4213. Within an allowable range of a process error, there may be a specific deviation between the thickness of the light shielding layer 421 and the depth of the third space 4213. For example, the top surface 4221 of the second light shielding sublayer 422 has specific undulation.

In some implementations, a surface that is of the bottom wall 4211 of the first light shielding sublayer 421 and that is close to the drive backplane 10 forms the bottom surface 424 of the light shielding layer 42. A bottom surface of the first light shielding sublayer 421 is a surface that is of the bottom wall 4211 of the first light shielding sublayer 421 and that is close to the drive backplane 10. The top surface 4221 of the second light shielding sublayer 422 and a top surface of the side wall 4122 of the first light shielding sublayer 421 jointly form the top surface 423 of the light shielding layer 42. The top surface of the side wall 4122 of the first light shielding sublayer 421 is a surface that is of the side wall 4122 and that is away from the drive backplane 10.

The top surface 423 of the light shielding layer 42 and a top surface of the insulation layer 41 form a top surface of the filling layer. A surface that is of the side wall 49 of the insulation layer 41 and that is away from the drive backplane 10 is a top surface of the insulation layer 41.

The insulation layer 41 may be configured to implement insulation between adjacent pixel structures 30, insulation between the drive backplane 10 and the light shielding layer 42, and insulation between the pixel structures 30 and the light shielding layer 42. In addition, the insulation layer 41 may further repair the side surface 313 of the pixel structure 30.

Thickness of the bottom wall 48 and the side wall 49 of the insulation layer 41 is greater than or equal to 5 nanometers and less than or equal to 500 nanometers. In an implementation, the first insulation sublayer 411 and the second insulation sublayer 412 are made of a same material and have a same preparation process, and the insulation layer 41 needs to be obtained by using only one process. In another implementation, the thickness of the bottom wall 48 and the side wall 49 of the insulation layer 41 may alternatively be greater than or equal to 500 nanometers, or less than 5 nanometers.

A preparation process of the insulation layer 41 may be an atomic layer deposition (atomic layer deposition, ALD) process or plasma enhanced chemical vapor deposition (plasma enhanced chemical vapor deposition, PECVD).

A material of the insulation layer 41 may include one or more of silicon dioxide (SiO₂), silicon nitride (SiNₓ), silicon oxynitride (SiON), aluminum oxide (Al₂O₃), zirconium trioxide (ZrO₃), hafnium dioxide (HfO₂), titanium dioxide (TiO₂), aluminum nitride (AlN), and dizinc oxide (ZnO₂).

In some implementations, for a manner of setting the thickness of the first light shielding sublayer 421, refer to the manner of setting the thickness of the first light shielding sublayer 421 (as shown in FIG. 3 and FIG. 4) in the foregoing implementations.

In some implementations, thickness of the second light shielding sublayer 422 in the thickness direction of the display panel 100 is greater than or equal to 100 nanometers and less than or equal to 2000 nanometers. In another implementation, the thickness of the second light shielding sublayer 422 in the thickness direction of the display panel 100 may alternatively be greater than 2000 nanometers or less than 100 nanometers.

For a preparation process and a material setting manner of the first light shielding sublayer 421 shown in FIG. 21, refer to the preparation process and the material setting manner of the first light shielding sublayer 421 (as shown in FIG. 3 and FIG. 4) in the foregoing implementations. For a preparation process and a material setting manner of the second light shielding sublayer 422 shown in FIG. 21, refer to the preparation process and the material setting manner of the second light shielding sublayer 428 (as shown in FIG. 3 and FIG. 4) in the foregoing implementations.

The top surface 423 of the light shielding layer 42 and the top surface of the insulation layer 41 form the top surface 43 of the filling layer 40. The top surface 311 of the pixel structure 30 is flush with the top surface 43 of the filling layer 40, that is, the top surface 423 of the light shielding layer 42 and the top surface of the insulation layer 41 are flush with the top surface 311 of the pixel structure 30. The top surface of the side wall 49 of the insulation layer 41 forms the top surface of the insulation layer 41. The top surface of the insulation layer 41 faces away from the drive backplane 10. A bottom surface of the bottom wall 48 of the insulation layer 41 forms a bottom surface of the insulation layer 41.

For preparing the display panel 100 shown in FIG. 21, refer to the foregoing method for preparing the display panel 100 (as shown in FIG. 5 to FIG. 20). A difference lies in that step 6 and step 7 in the preparation method are combined, a to-be-processed insulation layer is directly formed by using a conformal thin film deposition process, and step 10 is deleted.

For example, the conducting layer 50 is connected to the pixel structure 30, the insulation layer 41, the first light shielding sublayer 421, and the second light shielding sublayer 422.

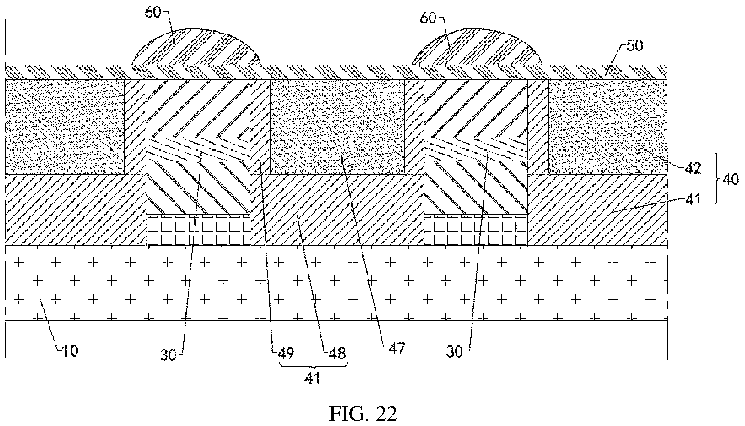

FIG. 22 is a partial sectional view of still another implementation of the display panel 100 shown in FIG. 2 at A-A.

In the display panel 100 shown in FIG. 22, the filling layer 40 may include the insulation layer 41 and the light shielding layer 42. Neither the insulation layer 41 nor the light shielding layer 42 is layered. The light shielding layer 42 is located in the first accommodation space 47 including the bottom wall 48 and the side wall 49 of the insulation layer 41.

It may be understood that, in some implementations, only one insulation layer 41 is disposed, so that a preparation process is reduced and the process is accelerated without affecting insulation effect of the insulation layer 41.

In another implementation, the filling layer 40 of the display panel 100 may include the first insulation sublayer 411, the second insulation sublayer 412, and the light shielding layer 42.

In another implementation, in some implementations, the dielectric layer 90 may further be disposed on the filling layer 40 of the display panel 100. For example, the filling layer 40 may include the insulation layer 41, the light shielding layer 42, and the dielectric layer. The bottom wall 48 and the side wall 49 of the insulation layer 41 form the first accommodation space 47, the bottom wall of the light shielding layer 42 and the side wall of the light shielding layer 42 form second accommodation space, and the dielectric layer is located in the second accommodation space, and is fastened to the light shielding layer.

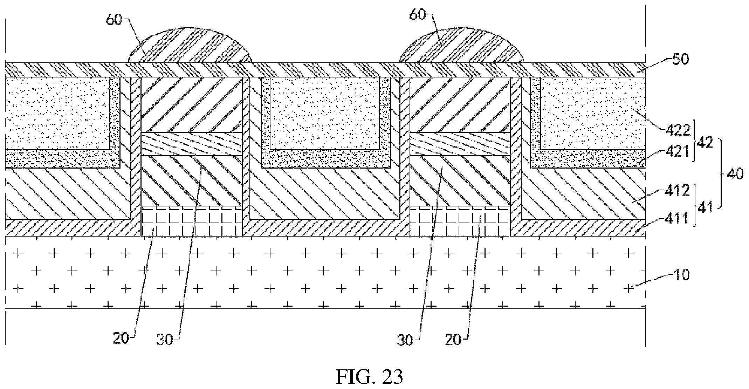

In some implementations, technical content that is the same as that of the display panel 100 (as shown in FIG. 3, FIG. 4, FIG. 21, and FIG. 22) in the foregoing implementations is not described again. FIG. 23 is a partial sectional view of yet another implementation of the display panel 100 shown in FIG. 2 at A-A.

As shown in FIG. 23, the filling layer 40 may include the insulation layer 41 and the light shielding layer 42. The insulation layer 41 includes the first insulation sublayer 411 and the second insulation sublayer 412. The light shielding layer 42 includes the first light shielding sublayer 421 and the second light shielding sublayer 422.

For disposing manners of the first insulation sublayer 411, the second insulation sublayer 412, and the first light shielding sublayer 421 shown in FIG. 23, refer to the disposing manners of the first insulation sublayer 411, the second insulation sublayer 412, and the first light shielding sublayer 421 (as shown in FIG. 3 and FIG. 4) in the foregoing implementations. For a disposing manner of the second light shielding sublayer 422 shown in FIG. 23, refer to the disposing manner of the second light shielding sublayer 422 (as shown in FIG. 21) in the foregoing implementations.

The conducting layer 50 is disposed on a side that is of the pixel structure 30 and the filling layer 40 and that is away from the drive backplane 10.

For example, the conducting layer 50 is connected to the pixel structure 30, the first insulation sublayer 411, the second insulation sublayer 412, the first light shielding sublayer 421, and the second light shielding sublayer 422.

For preparing the display panel 100 shown in FIG. 23, refer to the foregoing method for preparing the display panel 100 (as shown in FIG. 5 to FIG. 20). A difference lies in that step 10 is deleted.

In another implementation, the filling layer 40 may alternatively be a plurality of insulation layers 41 and a plurality of light shielding layers 42 that are stacked.

In this application, several structures of the display panel 100 are specifically described with reference to related accompanying drawings. It may be understood that, in this application, the filling layer 40 is disposed between two adjacent pixel structures 30 of the display panel 100, and the filling layer 40 includes the insulation layer 41 and the light shielding layer 42. Therefore, insulation protection is performed on the two adjacent pixel structures 30 through the insulation layer 41, and the light emitted from the side surface 313 of the pixel structure 30 is shielded through the light shielding layer 42. This avoids the optical crosstalk between the two adjacent pixel structures 30, that is, light emitted from the side surface 313 of one pixel structure 30 is not prone to being propagated to the other pixel structure 30. In particular, when the display panel 100 displays a frame of picture, if one of two adjacent pixel structures 30 needs to emit light and the other does not emit light, light from the pixel structure 30 that is emitting light is not prone to crosstalk to the pixel structure 30 that does not emit light.

In addition, the light shielding layer 42 may use a material whose reflectivity to visible light is higher than 80%. In this way, most of the light emitted from the side surface of the pixel structure 30 can be reflected back, so that the light can still be emitted from the top surface of the pixel structure 30. This avoids energy waste, and helps reduce energy consumption of the display panel 100. Further, the light shielding layer 42 may further use a metal material whose reflectivity to visible light is higher than 80%. In this way, the light shielding layer 42 may further assist the pixel structure 30 in heat dissipation while shielding light. In a running process of the display panel 100, the pixel structure 30 is not prone to being faulty due to overheating. This helps prolong a service life of the display panel 100.

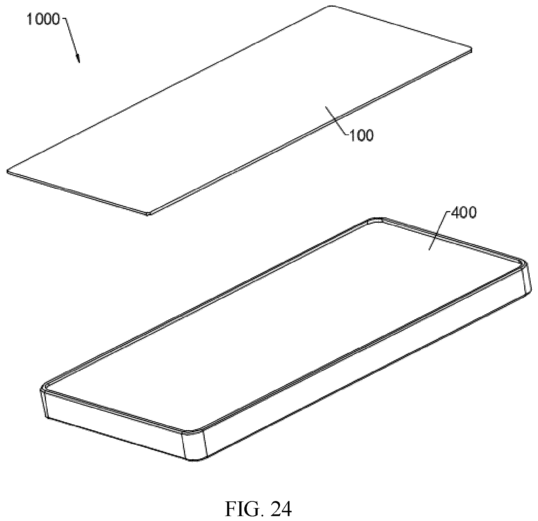

FIG. 24 is a diagram of a structure of an implementation of an electronic device 1000 according to an embodiment of this application.

This application provides an electronic device 1000. The electronic device 1000 may alternatively be a device having a display panel, for example, a mobile phone, a tablet computer (tablet computer), a laptop computer (laptop computer), a personal digital assistant (personal digital assistant, PDA), a notebook computer, or an in-vehicle device. The electronic device 1000 in the embodiment shown in FIG. 24 is described by using a mobile phone as an example.

As shown in FIG. 24, the electronic device 1000 includes a display panel 100 and a bearing member 400. For a structure of the display panel 100, refer to the structure of the display panel 100 in the foregoing embodiments (as shown in FIG. 2 to FIG. 23). The display panel 100 is configured to display an image. The bearing member 400 may be used as a structural bearing member of the display panel 100. When the electronic device 1000 is a mobile phone, the bearing member 400 may be a housing of the mobile phone. It may be understood that a specific form and structure of the bearing member 400 may change based on an actual situation, so that the bearing member 400 may be configured to bear the display panel 100. This is not specifically limited in this application.

It should be noted that embodiments in this application and features in embodiments may be combined with each other without a conflict, and any combination of features in different embodiments also falls within the protection scope of this application. In other words, the foregoing described plurality of embodiments may further be combined according to an actual requirement.

It should be noted that all the foregoing accompanying drawings are example diagrams of this application, and do not represent an actual size of a product. In addition, a size proportion relationship between components in the accompanying drawings is not intended to limit an actual product in this application.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel, comprising a drive backplane, a filling layer, and a plurality of pixel structures, wherein the filling layer is fastened to the drive backplane, the plurality of pixel structures are fastened to the drive backplane at intervals and are embedded in the filling layer, and the drive backplane is configured to drive the plurality of pixel structures to emit light; and
the filling layer comprises an insulation layer and a light shielding layer, the insulation layer comprises a bottom wall and a side wall, the bottom wall of the insulation layer and the side wall of the insulation layer form first accommodation space, the bottom wall of the insulation layer is fastened to the drive backplane, the side wall of the insulation layer is fastened to a side surface of the pixel structure, and the light shielding layer is located in the first accommodation space and fastened to the insulation layer.

2. The display panel according to claim 1, wherein the pixel structure comprises a light emitting layer, a bottom surface of the light emitting layer faces the drive backplane, the light shielding layer comprises a bottom surface, and the bottom surface of the light shielding layer is fastened to the insulation layer; and
in a thickness direction of the display panel, a distance between the bottom surface of the light shielding layer and the drive backplane is less than or equal to a distance between the bottom surface of the light emitting layer and the drive backplane.

3. The display panel according to claim 1 or 2, wherein the pixel structure comprises the light emitting layer, a top surface of the light emitting layer faces away from the drive backplane, the light shielding layer comprises a top surface, and the top surface of the light shielding layer faces away from the bottom wall of the insulation layer; and
in the thickness direction of the display panel, a distance between the top surface of the light shielding layer and the drive backplane is greater than or equal to a distance between the top surface of the light emitting layer and the drive backplane.

4. The display panel according to any one of claims 1 to 3, wherein a material of the light shielding layer is a metal material.

5. The display panel according to any one of claims 1 to 4, wherein a material of the insulation layer is one or more of silicon dioxide, silicon nitride, silicon oxynitride, aluminum oxide, zirconium trioxide, hafnium dioxide, titanium dioxide, aluminum nitride, and zinc dioxide.

6. The display panel according to any one of claims 1 to 5, wherein the light shielding layer comprises a bottom wall and a side wall, the bottom wall of the light shielding layer and the side wall of the light shielding layer form second accommodation space, the bottom wall of the light shielding layer is fastened to the bottom wall of the insulation layer and the side wall of the insulation layer, and the side wall of the light shielding layer is fastened to the side wall of the insulation layer; and
the filling layer further comprises a dielectric layer, and the dielectric layer is located in the second accommodation space and is fastened to the light shielding layer.

7. The display panel according to claim 6, wherein the dielectric layer comprises a top surface, the insulation layer comprises a top surface, the top surface of the dielectric layer, the top surface of the light shielding layer, the top surface of the insulation layer, and a top surface of the pixel structure are flush, and the top surface of the dielectric layer, the top surface of the light shielding layer, the top surface of the insulation layer, and the top surface of the pixel structure all face away from the drive backplane.

8. The display panel according to claim 6, wherein the light shielding layer comprises a first light shielding sublayer and a second light shielding sublayer, and adhesion between the first light shielding sublayer and the insulation layer is greater than adhesion between the second light shielding sublayer and the insulation layer;
the first light shielding sublayer comprises a bottom wall and a side wall, the bottom wall of the first light shielding sublayer and the side wall of the first light shielding sublayer form third space, the bottom wall of the first light shielding sublayer is fastened to the bottom wall of the insulation layer and the side wall of the insulation layer, and the side wall of the first light shielding sublayer is fastened to the side wall of the insulation layer;
the second light shielding sublayer is disposed in the third space, the second light shielding sublayer comprises a bottom wall and a side wall, the bottom wall of the second light shielding sublayer is fastened to the bottom wall of the first light shielding sublayer and the side wall of the first light shielding sublayer, the side wall of the second light shielding sublayer is fastened to the side wall of the first light shielding sublayer, the bottom wall of the second light shielding sublayer and the bottom wall of the first light shielding sublayer form the bottom wall of the light shielding layer, and the side wall of the second light shielding sublayer and the side wall of the first light shielding sublayer form the side wall of the light shielding layer; and
the bottom wall of the second light shielding sublayer and the side wall of the second light shielding sublayer form fourth space, and the fourth space forms the second accommodation space.

9. The display panel according to any one of claims 1 to 4, wherein the light shielding layer comprises a first light shielding sublayer and a second light shielding sublayer, and adhesion between the first light shielding sublayer and the insulation layer is greater than adhesion between the second light shielding sublayer and the insulation layer; and
the first light shielding sublayer comprises a bottom wall and a side wall, the bottom wall of the first light shielding sublayer is fastened to the bottom wall of the insulation layer and the side wall of the insulation layer, the side wall of the first light shielding sublayer is fastened to the side wall of the insulation layer, the bottom wall of the first light shielding sublayer and the side wall of the first light shielding sublayer form third space, and the second light shielding sublayer fills the third space.

10. The display panel according to any one of claims 1 to 9, wherein the insulation layer comprises a first insulation sublayer and a second insulation sublayer that are stacked, a material of the first insulation sublayer is non-silicon oxide or non-silicon nitride, and a material of the second insulation sublayer is silicon oxide or silicon nitride;
the first insulation sublayer comprises a bottom wall and a side wall, the bottom wall of the first insulation sublayer is fastened to the drive backplane, the side wall of the first insulation sublayer is fastened to the side surface of the pixel structure, and the bottom wall of the first insulation sublayer and the side wall of the first insulation sublayer form first space;
the second insulation sublayer is disposed in the first space, the second insulation sublayer comprises a bottom wall and a side wall, the bottom wall of the second insulation sublayer is fastened to the bottom wall of the first insulation sublayer and the side wall of the first insulation sublayer, the side wall of the second insulation sublayer is fastened to the side wall of the first insulation sublayer, the bottom wall of the first insulation sublayer and the bottom wall of the second insulation sublayer form the bottom wall of the insulation layer, and the side wall of the first insulation sublayer and the side wall of the second insulation sublayer form the side wall of the insulation layer; and
the bottom wall of the second insulation sublayer and the side wall of the second insulation sublayer form second space, and the second space forms the first accommodation space.

11. The display panel according to any one of claims 1 to 10, wherein the display panel further comprises a conducting layer, the conducting layer is fastened to the top surface of the insulation layer, the top surface of the light shielding layer, and the top surface of the pixel structure, and the top surface of the pixel structure faces away from the drive backplane; and
the conducting layer is electrically connected to the pixel structure.

12. The display panel according to any one of claims 1 to 11, wherein a height of the pixel structure in the thickness direction of the display panel is less than or equal to 2 micrometers, and a pitch between adjacent pixel structures is less than or equal to 2 micrometers.

13. The display panel according to any one of claims 1 to 12, wherein a size of the display panel is less than or equal to 0.5 inch.

14. An electronic device, comprising a bearing member and the display panel according to any one of claims 1 to 13, wherein the bearing member is configured to bear the display panel.

15. The electronic device according to claim 14, wherein the bearing member comprises a lens frame and a frame temple, the frame temple is connected to the lens frame, and the display panel is mounted on the frame temple.

16. The electronic device according to claim 15, wherein there are two display panels and two frame temples, the two frame temples are respectively connected to two ends of the lens frame, and the two display panels are respectively mounted on the two frame temples.

17. The electronic device according to claim 14, wherein the electronic device comprises augmented reality glasses, virtual reality glasses, mixed reality glasses, an augmented reality helmet, a virtual reality helmet, a mixed reality helmet, a head-up display device, or a projector.
